# EUROPEAN PATENT APPLICATION

(11) **EP 4 682 688 A1**
(43) Date of publication of application: **21.01.2026**
(21) Application number: 25715657.0
(22) Date of filing: 17.03.2025
(51) Int. Cl.: G06F 3/01, G06F 3/02, H02N 2/02, H05K 1/02

(54) **ELECTRONIC DEVICE COMPRISING SENSOR AND KEY BUTTON STRUCTURE FOR PROVIDING HAPTIC FEEDBACK**

(30) Priority: 31.05.2024 KR 20240071979; 03.07.2024 KR 20240087843
(71) Applicant: Samsung Electronics Co., Ltd., Suwon-si, Gyeonggi-do 16677 (KR)
(72) Inventor: YI, Yongseung, Suwon-si, Gyeonggi-do 16677 (KR); PARK, Hyunjun, Suwon-si, Gyeonggi-do 16677 (KR); LIM, Hyeoksoo, Suwon-si, Gyeonggi-do 16677 (KR); JUNG, Daekwang, Suwon-si, Gyeonggi-do 16677 (KR)
(74) Representative: HGF
(86) International application number: PCT/KR2025/003457
(87) International publication number: WO 2025/249723

(57) **Abstract**

According to an embodiment, the electronic device includes a housing including a recess, and a key button including a head portion partially disposed in the recess, and a shaft portion extending from the head portion toward an inside of the electronic device. The electronic device includes a printed circuit board disposed toward the key button within the housing, an actuator, disposed between the printed circuit board and the key button, configured to provide haptic feedback to the head portion based on pressure exerted by the shaft portion, and a sensor configured to detect the pressure. The printed circuit board includes a mounting portion on which the sensor is disposed, spaced apart from the actuator, and a connecting portion, which is deformable, extending from the mounting portion to electrically connect the actuator and the mounting portion.

## Description

### [Technical Field]

The present disclosure relates to an electronic device including a sensor and a key button structure for providing haptic feedback.

### [Background Art]

An electronic device may include a key button for executing various functions of the electronic device. In particular, when a user applies pressure to the key button this may be sensed by a sensor, and cause the electronic device to execute a function.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In order to meet a user's request, a key button of an electronic device may perform another function in addition to a function that causes a preset function of the electronic device. For example, the key button may provide haptic feedback to the user, based on a user input. In order to provide various user experiences, the electronic device may comprise a sensor for providing various haptic feedback and a structure for the key button linked with the sensor.

An electronic device is disclosed. The electronic device may comprise a housing including a recess. The electronic device may comprise a key button including a head portion partially disposed in the recess, and a shaft portion extending from the head portion toward an inside of the electronic device. The electronic device may comprise a printed circuit board disposed toward the key button within the housing. The electronic device may comprise an actuator, disposed between the printed circuit board and the key button, configured to provide haptic feedback to the head portion based on pressure exerted by the shaft portion. The electronic device may comprise a sensor configured to detect the pressure. The printed circuit board may include a mounting portion, on which the sensor is disposed, spaced apart from the actuator, and a connecting portion, which is deformable, extending from the mounting portion to electrically connect the actuator and the mounting portion.

An electronic device is disclosed. The electronic device may comprise a housing including a recess, and first and second through holes, connecting with the recess, spaced apart from each other. The electronic device may comprise a key button including a head portion partially accommodated in the recess, a first shaft portion extending from the head portion toward an inside of the electronic device through the first through hole, and a second shaft portion extending from the head portion toward the inside through the second through hole. The electronic device may comprise a printed circuit board disposed toward the key button within the housing. The electronic device may comprise an actuator, disposed between the printed circuit board and the key button, configured to provide haptic feedback to the head portion based on pressure exerted by the key button. The electronic device may comprise at least one sensor configured to detect the pressure. The printed circuit board may include a mounting portion, on which the at least one sensor is disposed, spaced apart from the actuator, and a connecting portion, which is deformable, extending from the mounting portion to electrically connect the actuator and the mounting portion.

### [Description of the Drawings]

FIG. 1 is a block diagram of an electronic device in a network environment according to various embodiments.
FIG. 2A is a diagram indicating an exemplary electronic device.
FIG. 2B is an exploded perspective view of an exemplary electronic device.
FIG. 3 is a partially exploded perspective view of an exemplary electronic device.
FIG. 4A illustrates an internal structure of an exemplary electronic device.
FIGS. 4B and 4C are exploded views of a key button assembly of an exemplary electronic device.
FIG. 4D is an exploded perspective view of a key button assembly of an exemplary electronic device.
FIG. 5A is a partial cross-sectional view of an exemplary electronic device cut along line A-A' of FIG. 2A.
FIG. 5B is a partial cross-sectional view of an exemplary electronic device cut along line B-B' of FIG. 5A.
FIGS. 5C and 5D illustrate a key button assembly of an exemplary electronic device.
FIG. 6 illustrates an internal structure of an exemplary electronic device in which a key button assembly is disposed.
FIGS. 7A and 7B illustrate an internal structure of an exemplary electronic device.

### [Mode for Invention]

Terms used in the present disclosure are used only to describe specific examples, and are not intended to limit other examples. Singular forms include plural referents unless otherwise specified in the context. The terms and words used in the present disclosure, including technical or scientific terms, may have substantially the same meanings as those generally understood by those skilled in the art. The terms generally defined in a dictionary may be interpreted as substantially the same or similar meanings of a relevant technical field in the context. However, unless otherwise defined in the present disclosure, corresponding terms should not be interpreted in ideal or overly formal meanings, and even if the terms are defined in the present disclosure, the corresponding terms should not be interpreted as excluding examples of the present disclosure according to a certain circumstance.

For example, the term "couple" and its derivatives may mean direct or indirect communication between two or more elements regardless of whether they are in physical contact with each other. For example, the terms "transmit," "receive," and "communicate" and their derivatives include both direct and indirect communication. The terms "include" and "comprise" and their derivatives may mean inclusion without limitation. For example, the term "or" may be a comprehensive term that means "and/or". For example, a phrase "at least one" used with a list of items may mean that various combinations of one or more of the listed items may be used and only one item may be required in the list.

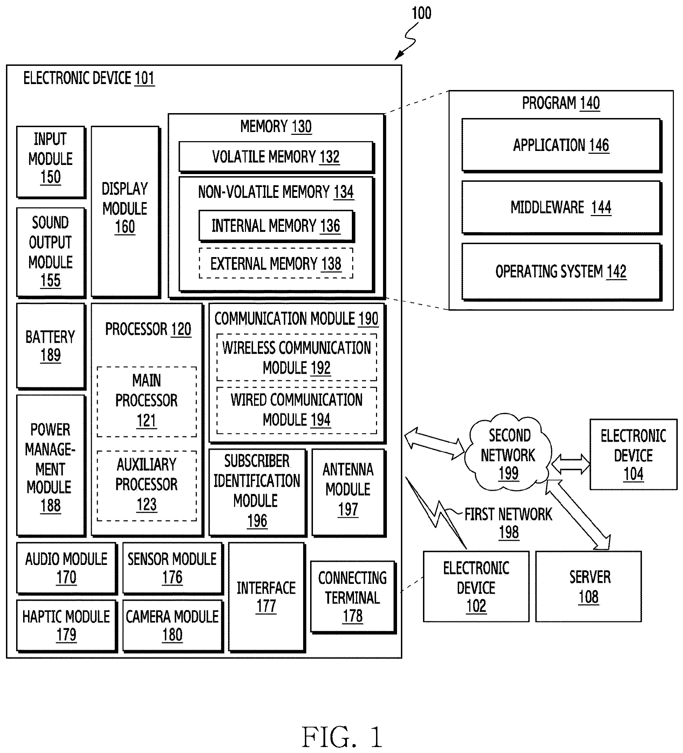

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

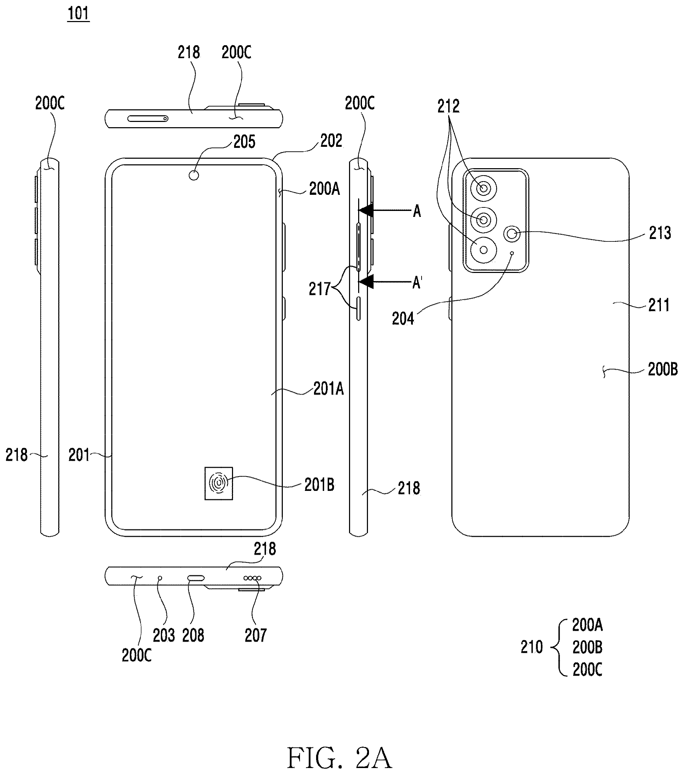

FIG. 2A is a diagram indicating an exemplary electronic device.

Referring to FIG. 2A, an electronic device 200 according to an embodiment may include a housing 210 forming an exterior of the electronic device 200. For example, the housing 210 may include a front surface 200A, a rear surface 200B, and a lateral side 200C surrounding a space between the front surface 200A and the rear surface 200B. According to an embodiment, the housing 210 may refer to a structure forming at least a portion of the front surface 200A, the rear surface 200B, and/or the lateral side 200C.

According to an embodiment, the electronic device 200 may include a substantially transparent front plate 202. According to an embodiment, the front plate 202 may form at least a portion of the front surface 200A. According to an embodiment, the front plate 202 may include, for example, a glass plate or a polymer plate, including various coating layers, but is not limited thereto.

According to an embodiment, the electronic device 200 may include a substantially opaque rear plate 211. According to an embodiment, the rear plate 211 may form at least a portion of the rear surface 200B. According to an embodiment, the rear plate 211 may be formed of coated or colored glass, ceramic, polymer, a metal (e.g., aluminum, stainless steel (STS), or magnesium), or a combination of at least two of the above materials.

According to an embodiment, the electronic device 200 may include a later side bezel structure (or a lateral side member) 218. According to an embodiment, the lateral side bezel structure 218 may be coupled to the front plate 202 and/or the rear plate 211 to form at least a portion of the lateral side 200C of the electronic device 200. For example, the lateral side bezel structure 218 may form the entire lateral side 200C of the electronic device 200, and for another example, the lateral side bezel structure 218 may form the lateral side 200C of the electronic device 200 together with the front plate 202 and/or the rear plate 211.

Unlike the illustrated embodiment, in case that the lateral side 200C of the electronic device 200 is partially formed by the front plate 202 and/or the rear plate 211, the front plate 202 and/or the rear plate 211 may include a region that is seamlessly extended by being bent toward the rear plate 211 and/or the front plate 202 at its periphery. For example, the extending region of the front plate 202 and/or the rear plate 211 may be positioned at both ends of a long edge of the electronic device 200 but is not limited by the above-described example.

According to an embodiment, the lateral side bezel structure 218 may include the metal and/or the polymer. According to an embodiment, the rear plate 211 and the lateral side bezel structure 218 may be integrally formed, and may include the same material (e.g., a metal material such as the aluminum), but are not limited thereto. For example, the rear plate 211 and the lateral side bezel structure 218 may be formed in a separate configuration and/or may include a different material.

According to an embodiment, the electronic device 200 may include at least one of a display 201, an audio module 203, 204, or 207, a sensor module (not illustrated), a camera module 205, 212, or 213, a key input device 217, a light emitting element (not illustrated), and/or a connector hole 208. According to an embodiment, the electronic device 200 may omit at least one (e.g., the key input device 217 or the light emitting device (not illustrated)) of the components or may additionally include another component.

According to an embodiment, the display 201 may be visually exposed through a significant portion of the front plate 202. For example, at least a portion of the display 201 may be visible through the front plate 202 forming the front surface 200A. According to an embodiment, the display 201 may be disposed on a back surface of the front plate 202.

According to an embodiment, an outer shape of the display 201 may be formed generally the same as an outer shape of the front plate 202 adjacent to the display 201. According to an embodiment, in order to expand an area in which the display 201 is visually exposed, a distance between an outer periphery of the display 201 and an outer periphery of the front plate 202 may be formed generally the same.

According to an embodiment, the display 201 (or the front surface 200A of the electronic device 200) may include a screen display region 201A. According to an embodiment, the display 201 may provide visual information to a user through the screen display region 201A. In the illustrated embodiment, when the front surface 200A is viewed frontally, the screen display region 201A is illustrated to be spaced apart from an outer periphery of the front surface 200A and positioned inside the front surface 200A, but is not limited thereto. In another embodiment, when the front surface 200A is viewed frontally, at least a portion of a periphery part of the screen display region 201A may substantially coincide with a periphery part of the front surface 200A (or the front plate 202).

According to an embodiment, the screen display region 201A may include a sensing region 201B configured to obtain biometric information of the user. Herein, the meaning of "the screen display region 201A includes the sensing region 201B" may be understood as at least a portion of the sensing region 201B overlapping with the screen display region 201A. For example, the sensing region 201B, like another region of the screen display region 201A, may mean a region capable of displaying the visual information by the display 201 and additionally obtaining the biometric information (e.g., fingerprint) of the user. According to an embodiment, the sensing region 201B may be formed in the key input device 217.

According to an embodiment, the display 201 may include a region in which a first camera 205 is positioned. According to an embodiment, an opening is formed in the region of the display 201, and the first camera 205 (e.g., a punch hole camera) may be at least partially disposed in the opening to face the front surface 200A. In this case, the screen display region 201A may surround at least a portion of a periphery part of the opening. According to an embodiment, the first camera 205 (e.g., an under display camera (UDC)) may be disposed under the display 201 to overlap with the region of the display 201. In this case, the display 201 may provide the visual information to the user through the region, and additionally, the first camera 205 may obtain an image corresponding to a direction facing the front surface 200A through the region of the display 201.

According to an embodiment, the display 201 may be coupled with or disposed adjacent to a touch sensing circuit, a pressure sensor capable of measuring a strength (pressure) of a touch, and/or a digitizer that detects a magnetic field-type stylus pen.

According to an embodiment, the audio module 203, 204, and 207 may include microphone holes 203 and 204 and a speaker hole 207.

According to an embodiment, the microphone holes 203 and 204 may include a first microphone hole 203 formed in a partial region of the lateral side 200C, and a second microphone hole 204 formed in a partial region of the rear surface 200B. A microphone (not illustrated) for obtaining an external sound may be disposed inside the microphone holes 203 and 204. The microphone may include a plurality of microphones to detect a direction of a sound.

According to an embodiment, the second microphone hole 204 formed in the partial region of the rear surface 200B may be disposed adjacent to the camera module 205, 212, and 213. For example, the second microphone hole 204 may obtain a sound according to an operation of the camera module 205, 212, and 213. However, it is not limited thereto.

According to an embodiment, the speaker hole 207 may include an external speaker hole 207 and a receiver hole for a call (not illustrated). The external speaker hole 207 may be formed on a portion of the lateral side 200C of the electronic device 200. According to an embodiment, the external speaker hole 207 may be implemented as one hole with the microphone hole 203. Although not illustrated, the receiver hole for a call (not illustrated) may be formed on another portion of the lateral side 200C. For example, the receiver hole for a call may be formed on an opposite side of the external speaker hole 207 on the lateral side 200C. For example, based on the illustration of FIG. 2A, the external speaker hole 207 may be formed on the lateral side 200C corresponding to a lower end of the electronic device 200, and the receiver hole for a call may be formed on the lateral side 200C corresponding to an upper end of the electronic device 200. However, it is not limited thereto, and according to an embodiment, the receiver hole for a call may be formed at a position other than the lateral side 200C. For example, the receiver hole for a call may be formed by a separated space between the front plate 202 (or the display 201) and the lateral side bezel structure 218.

According to an embodiment, the electronic device 200 may include at least one speaker (not illustrated) configured to output a sound to an outside of the housing through the external speaker hole 207 and/or the receiver hole for a call (not illustrated).

According to an embodiment, the sensor module (not illustrated) may generate an electrical signal or a data value corresponding to an internal operating state or an external environmental state of the electronic device 200. For example, the sensor module may include at least one of a proximity sensor, a HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera module 205, 212, and 213 may include the first camera 205 disposed to face the front surface 200A, and a second camera 212 disposed to face the rear 200B, and a flash 213 of the electronic device 200.

According to an embodiment, the second camera 212 may include a plurality of cameras (e.g., a dual camera, a triple camera, or a quad camera). However, the second camera 212 is not necessarily limited to including the plurality of cameras, and may include one camera.

According to an embodiment, the first camera 205 and the second camera 212 may include one or a plurality of lenses, an image sensor, and/or an image signal processor.

According to an embodiment, the flash 213 may include, for example, a light emitting diode or a xenon lamp. According to an embodiment, two or more lenses (an infrared camera, a wide-angle and telephoto lens) and image sensors may be disposed on a surface of the electronic device 200.

According to an embodiment, the key input device 217 may be disposed on the lateral side 200C of the electronic device 200. According to an embodiment, the electronic device 200 may not include a portion or all of the key input device 217, and the key input device 217 that is not included may be implemented in another form such as a soft key on the display 201.

According to an embodiment, the connector hole 208 may be formed on the lateral side 200C of the electronic device 200 such that a connector of an external device may be accommodated. A connecting terminal (e.g., the connecting terminal 178 of FIG. 1) electrically connected to the connector of the external device may be disposed in the connector hole 208. According to an embodiment, the electronic device 200 may include an interface module for processing an electrical signal transmitted and received through the connecting terminal.

According to an embodiment, the electronic device 200 may include the light emitting element (not illustrated). For example, the light emitting element (not illustrated) may be disposed on the front surface 200A of the housing. The light emitting element (not illustrated) may provide state information of the electronic device 200 in an optical form. According to an embodiment, the light emitting element (not illustrated) may provide a light source linked with an operation of the first camera 205. For example, the light emitting element (not illustrated) may include an LED, an IR LED, and/or the xenon lamp.

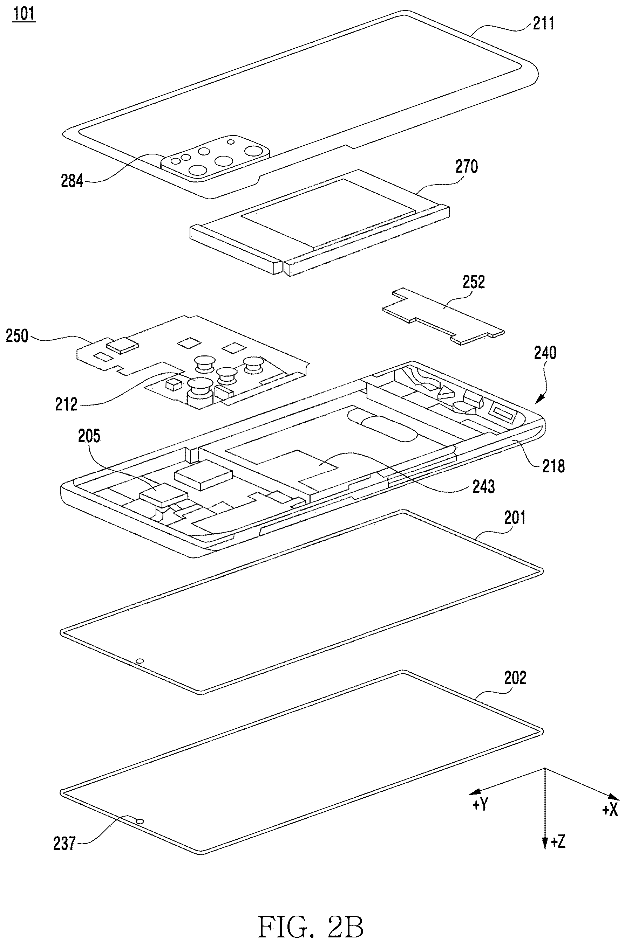

FIG. 2B is an exploded perspective view of an exemplary electronic device.

Hereinafter, an overlapping description with respect to a configuration having the same reference code as the above-described configuration will be omitted.

Referring to FIG. 2B, according to an embodiment, the electronic device 200 may include a frame structure 240, a first printed circuit board 250, a second printed circuit board 252, a cover plate 260, and a battery 270.

According to an embodiment, the frame structure 240 may include the lateral side bezel structure 218 forming an exterior (e.g., the lateral side 200C of FIG. 2A) of the electronic device 200, and a support portion 243 extended inward from the lateral side bezel structure 218. According to an embodiment, the frame structure 240 may be disposed between the display 201 and the rear plate 211. According to an embodiment, the lateral side bezel structure 218 of the frame structure 240 may surround a space between the rear plate 211 and the front plate 202 (and/or the display 201), and the support portion 243 of the frame structure 240 may be extended from the lateral side bezel structure 218 in the space.

According to an embodiment, the frame structure 240 may support or accommodate other components included in the electronic device 200. For example, the display 201 may be disposed on a surface of the frame structure 240 facing in a direction (e.g., a +z direction), and the display 201 may be supported by the support portion 243 of the frame structure 240. For example, the first printed circuit board 250, the second printed circuit board 252, the battery 270, and the second camera 212 may be disposed on another surface facing an opposite direction (e.g., a -z direction) to the direction of the frame structure 240. The first printed circuit board 250, the second printed circuit board 252, the battery 270, and the second camera 212 may be respectively mounted on a recess defined by the lateral side bezel structure 218 and/or the support portion 243 of the frame structure 240.

According to an embodiment, the first printed circuit board 250, the second printed circuit board 252, and the battery 270 may be coupled with the frame structure 240, respectively. For example, the first printed circuit board 250 and the second printed circuit board 252 may be fixedly disposed in the frame structure 240 through a coupling member such as a screw. For example, the battery 270 may be fixedly disposed in the frame structure 240 through an adhesive member (e.g., a double-sided tape). However, it is not limited by the above-described example.

According to an embodiment, the cover plate 260 may be disposed between the first printed circuit board 250 and the rear plate 211. According to an embodiment, the cover plate 260 may be disposed on the first printed circuit board 250. For example, the cover plate 260 may be disposed on a surface of the first printed circuit board 250 facing the -z direction.

According to an embodiment, the cover plate 260 may at least partially overlap the first printed circuit board 250, based on a z-axis. According to an embodiment, the cover plate 260 may cover at least a partial region of the first printed circuit board 250. Through this, the cover plate 260 may protect the first printed circuit board 250 from a physical impact, or prevent a connector coupled to the first printed circuit board 250 from leaving.

According to an embodiment, the cover plate 260 may be fixedly disposed in the first printed circuit board 250 through the coupling member (e.g., the screw), or may be coupled to the frame structure 240 together with the first printed circuit board 250 through the coupling member.

According to an embodiment, the display 201 may be disposed between the frame structure 240 and the front plate 202. For example, the front plate 202 may be disposed on a side (e.g., the +z direction) of the display 201, and the frame structure 240 may be disposed on another side (e.g., the -z direction).

According to an embodiment, the front plate 202 may be coupled with the display 201. For example, the front plate 202 and the display 201 may be adhered to each other through an optical adhesive member (e.g., optically clear adhesive (OCA) or optically clear resin (OCR)) interposed therebetween.

According to an embodiment, the front plate 202 may be coupled with the frame structure 240. For example, the front plate 202 may include an outer portion extending outside the display 201 when viewed in the z-axis direction, and may be adhered to the frame structure 240 through the adhesive member (e.g., the double-sided tape) disposed between the outer portion of the front plate 202 and the frame structure 240 (e.g., the lateral side bezel structure 218). However, it is not limited by the above-described example.

According to an embodiment, a processor, memory, and/or an interface may be mounted on the first printed circuit board 250 and/or the second printed circuit board 252. For example, the processor may include one or more of a central processing unit, an application processor, a graphics processing unit, an image signal processor, a sensor hub processor, or a communication processor. For example, the memory may include a volatile memory or a non-volatile memory. For example, the interface may include a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. According to an embodiment, the first printed circuit board 250 and the second printed circuit board 252 may be operatively or electrically connected to each other through a connecting member (e.g., a flexible printed circuit board).

According to an embodiment, the battery 270 may supply power to at least one component of the electronic device 200. For example, the battery 270 may include a rechargeable secondary battery or a fuel cell. At least a portion of the battery 270 may be disposed substantially on the same plane as the first printed circuit board 250 and/or the second printed circuit board 252.

According to an embodiment, the electronic device 200 may include an antenna module (not illustrated). According to an embodiment, the antenna module may be disposed between the rear plate 211 and the battery 270. For example, the antenna module may include a near field communication (NFC) antenna, a wireless charging antenna, and/or a magnetic secure transmission (MST) antenna. For example, the antenna module may perform short-range communication with the external device or wirelessly transmit and receive the power with the external device.

According to an embodiment, the first camera 205 (e.g., a front camera) may be disposed in at least a portion (e.g., the support portion 243) of the frame structure 240 such that a lens may receive external light through a partial region (e.g., a camera region 237) of the front plate 202 (e.g., the front surface 200A of FIG. 1).

According to an embodiment, the second camera 212 (e.g., a rear camera) may be disposed between the frame structure 240 and the rear plate 211. According to an embodiment, the second camera 212 may be electrically connected to the first printed circuit board 250 through the connecting member (e.g., the connector). According to an embodiment, the second camera 212 may be disposed such that a lens may receive external light through a camera region 284 of the rear plate 211 of the electronic device 200.

According to an embodiment, the camera region 284 may be formed on a surface (e.g., the rear surface 200B of FIG. 1) of the rear plate 211. According to an embodiment, the camera region 284 may be at least partially transparently formed such that the external light may be incident on the lens of the second camera 212. According to an embodiment, at least a portion of the camera region 284 may protrude from the external surface of the rear plate 211 to a predetermined height. However, it is not limited thereto, and in another embodiment, the camera region 284 may form substantially the same plane as the external surface of the rear plate 211.

According to an embodiment, the housing (e.g., the housing 210 of FIG. 2A) of the electronic device 200 may mean a configuration or a structure forming at least a portion of the exterior of the electronic device 200. In this respect, at least a portion of the front plate 202, the frame structure 240, and/or the rear plate 211 forming the exterior of the electronic device 200 may be referred to as the housing 210 of the electronic device 200.

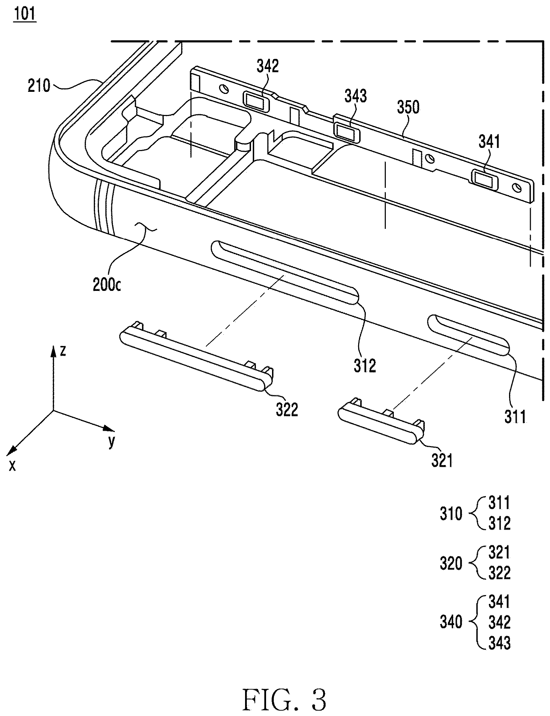

FIG. 3 is a partially exploded perspective view of an exemplary electronic device.

Referring to FIG. 3, an electronic device 101 may include a housing 210, which includes one or more holes 310 (or recesses), one or more key buttons 320 (e.g., the key input device 217 of FIG. 2A), one or more dome keys 340, and a printed circuit board 350.

The housing 210 may define an internal space of the electronic device 101 for accommodating electronic components (e.g., the printed circuit board 350) of the electronic device 101. For example, the housing 210 may include a front surface (e.g., the front surface 200A of FIG. 2A), a rear surface (e.g., the rear surface 200B of FIG. 2A) facing the front surface 200A and a lateral side 200C surrounding a space between the front surface 200A and the rear surface 200B. The space surrounded by the front surface 200A, the rear surface 200B, and the lateral side 200C may be referred to as the internal space of the electronic device 101.

The one or more holes 310 may be formed in the housing 210. In an embodiment, the one or more holes 310 may also include a recess. The one or more 310 may provide mounting spaces for receiving the one or more key buttons 320. For example, the one or more holes 310 may extend from the lateral side 200C of the housing 210 toward an inside of the electronic device 101. One or more of the one or more holes 310 may extend from the front surface 200A towards an inside of the electronic device. One or more of the one or more holes 310 may extend from the rear surface 200B towards an inside of the electronic device. The one or more holes 310 may be formed in a lateral side bezel structure (e.g., the lateral side bezel structure 218 of FIG. 2A) of the housing 210 that forms the lateral side 200C of the housing 210. The one or more holes 310 may be formed along the lateral side 200C. For example, in order that a first key button 321 interacts with a first dome key 341 positioned inside the electronic device 101, a first hole 311 may be penetrated by the first key button 321. In order that a second key button 322 interacts with a second dome key 342 and a third dome key 343 positioned inside the electronic device 101, a second hole 312 spaced apart from the first hole 311 may be penetrated by the second key button 322. However, an embodiment supported by the present disclosure is not limited thereto. However, the embodiment supported by the present disclosure is not limited thereto, and the electronic device 101 may include a plurality of key buttons configured to cause various functions of the electronic device 101 and a plurality of holes for receiving the plurality of key buttons.

The one or more key buttons 320 may be movably coupled in the one or more holes 310, respectively. For example, the one or more key buttons 320 may be exposed to an outside of electronic device 101 by being partially disposed in the one or more holes 310, respectively. As being pressed in a pressing direction (e.g., an -x direction), each of the one or more key buttons 320 may move in the pressing direction. As the pressing is released, the one or more key buttons 320 may be configured to be restored by moving in a direction opposite to the pressing direction.

The printed circuit board 350 may be disposed toward the one or more key buttons 320 and/or the one or more holes 310 in which the one or more key buttons 320 are disposed within the housing 210. Each of the one or more dome keys 340 may be disposed toward the one or more key buttons 320 by being mounted on the printed circuit board 350. For example, the printed circuit board 350 may be disposed toward the lateral side 200C of the housing 210 in the internal space of the electronic device 101. The one or more dome keys 340 may be disposed on a surface of the printed circuit board 350 facing the lateral side 200C. For example, the first dome key 341 may overlap the first key button 321 when the first key button 321 is viewed from above (e.g., when viewed in the -x direction). The second dome key 342 and the third dome key 343 may overlap the second key button 322 when the second key button 322 is viewed from above. For example, each of the one or more dome keys 340 may be configured to obtain an input signal by linking with the one or more key buttons 320. The one or more dome keys 340 may be aligned with the one or more key buttons 320 to be pressed respectively by the one or more key buttons 320. Each of the one or more dome keys 340 may be configured to obtain the input signal by being pressed by one or more corresponding key buttons 320.

For example, the first dome key 341 may cause execution of a power on/off function of the electronic device 101 or execution of an artificial intelligence function of the electronic device 101, by being pressed by the first key button 321. For example, the second dome key 342 and the third dome key 343 may cause execution of a volume up/down function of the electronic device 101 or a wake-up/sleep function of the electronic device 101, by being pressed by the second key button 322. However, the embodiment supported by the present disclosure is not limited thereto, and the electronic device 101 may include a plurality of key buttons for executing each of various functions of the electronic device 101 and a plurality of dome keys corresponding to each of the plurality of key buttons.

A processor (e.g., the processor 120 of FIG. 1) may receive the input signal obtained through the one or more dome keys 340. In the present disclosure, the processor 120 may be referred to as at least one processor or one or more processors including processing circuitry in the electronic device 101. In addition, instructions stored in one or more storage media included in memory (e.g., the memory 130 of FIG. 1) in the electronic device 101 may cause the electronic device 101 to perform operations and/or functions of the electronic device 101 assigned to each of the one or more dome keys 340, when executed individually or collectively by the processor 120.

For example, in response to receiving a first input signal obtained through the first dome key 341, the processor 120 may execute the power on/off function of the electronic device 101, which is a function assigned to the first input signal. For example, in response to receiving a second input signal obtained through the second dome key 342, the processor 120 may execute a volume increasing function of the electronic device 101, which is a function assigned to the second input signal. For example, in response to receiving a third input signal obtained through the third dome key 343, a volume decreasing function of the electronic device 101, which is a function assigned to the third input signal, may be executed. However, the functions of the electronic device 101 caused by the one or more key buttons 320 and the one or more dome keys 340 are not limited thereto.

Each of the one or more dome keys 340 may be deformed, based on pressure exerted by the one or more key buttons 320. As the pressure exerted to the one or more dome keys 340 is released, the one or more dome keys 340 may be restored to a state before the pressure is exerted. The one or more dome keys 340 may provide mechanical haptic feedback through the one or more key buttons 320 while being pressed or restored by the one or more key buttons 320.

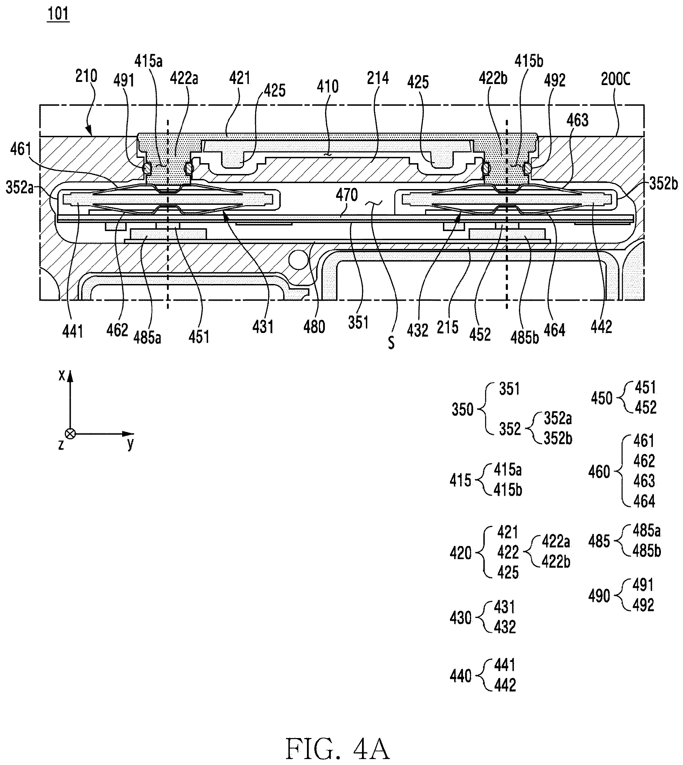

In order to provide various user experiences, the electronic device 101 may be required to provide various haptic feedback in addition to haptic feedback provided as the one or more dome keys 320 is pressed. For example, the electronic device 101 may be required to provide each of different haptic patterns according to the pressure exerted through the one or more key buttons 320, or to provide each of different haptic feedback according to a user input inputted through the one or more key buttons 320. In order to provide various haptic feedback, the electronic device 101 may be required a structure for providing the various haptic feedback, instead of the one or more dome keys 320, and a connecting structure around the one or more key buttons 320 for controlling the haptic feedback through the structure. A structure of the key button (or a key button assembly) of the electronic device 101 for providing the various haptic feedback is exemplarily described through illustration below FIG. 4A.

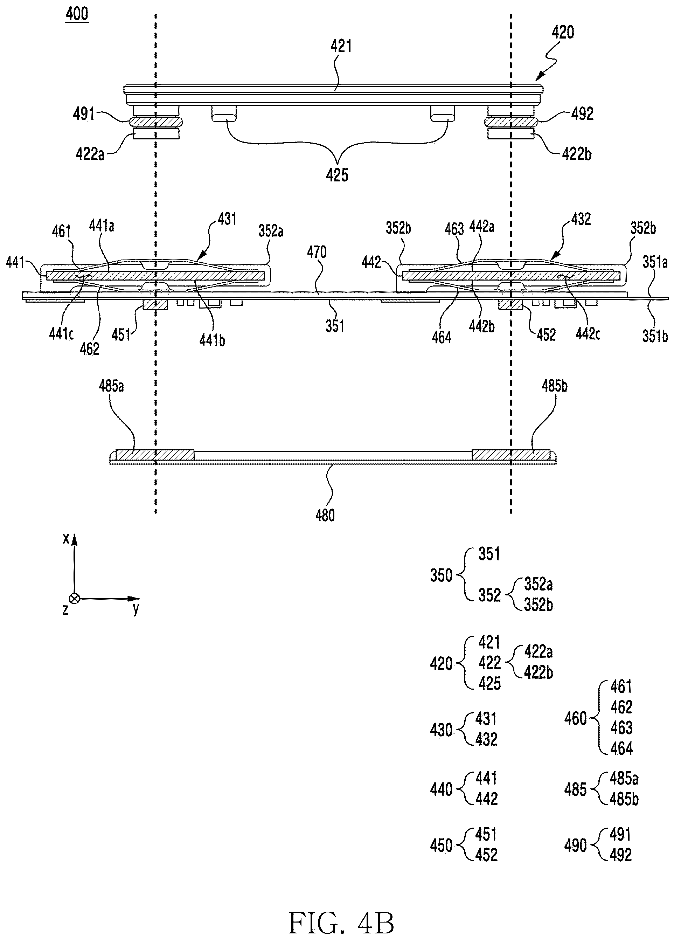

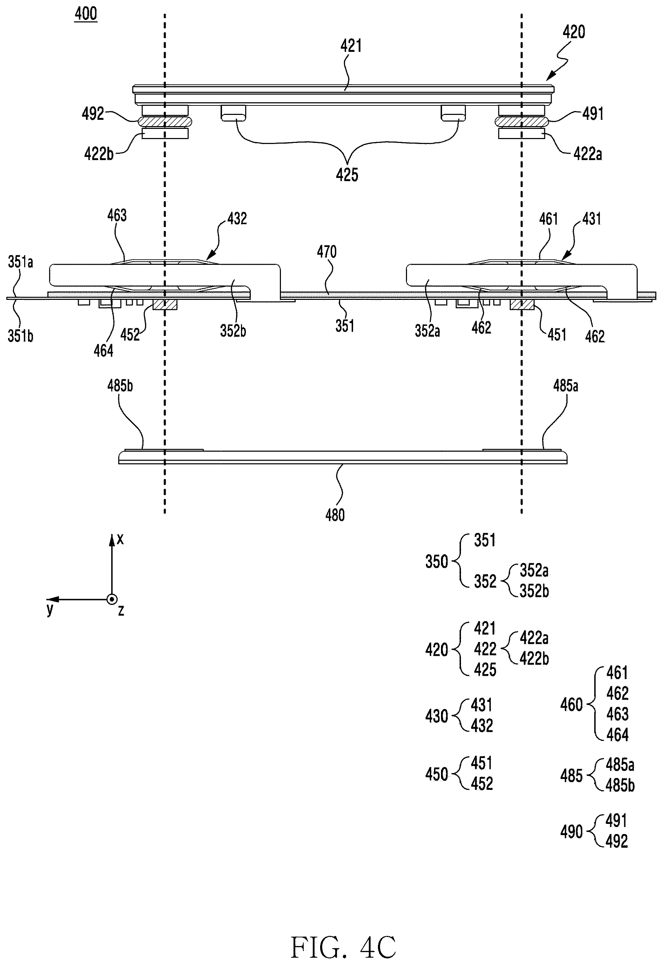

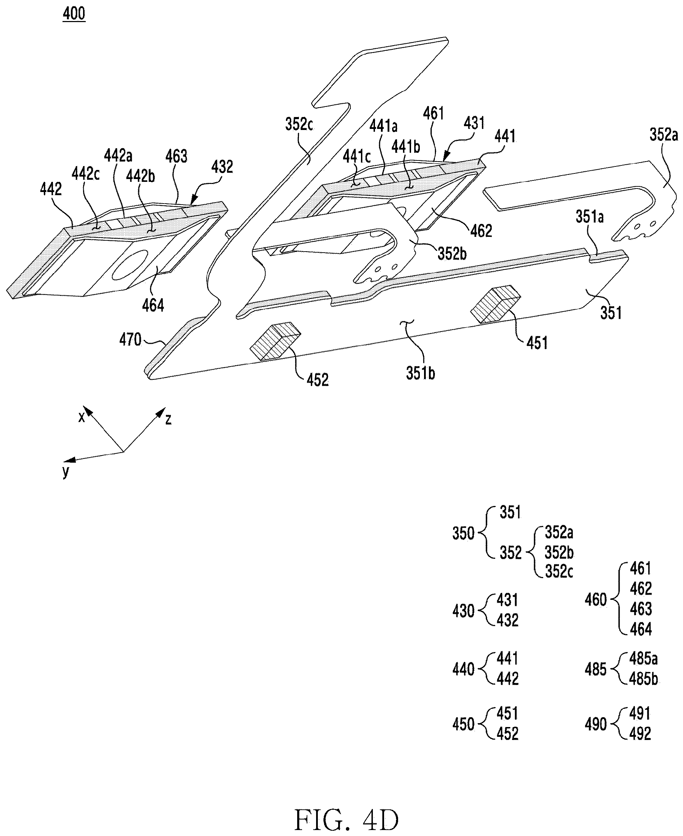

FIG. 4A illustrates an internal structure of an exemplary electronic device. FIG. 4B and FIG. 4C are exploded views of a key button assembly of an exemplary electronic device. FIG. 4D is an exploded perspective view of a key button assembly of an exemplary electronic device.

Referring to FIGS. 4A, 4B, 4C, and 4D, an electronic device 101 according to an embodiment may include a housing 210 including a recess 410, a key button 420 (e.g., the key input device 217 of FIG. 2A, or the one or more key buttons 320 of FIG. 3), a printed circuit board 350, an actuator 430, and/or a sensor 450.

According to an embodiment, the recess 410 of the housing 210 may provide a mounting space for the key button 420. For example, the recess 410 may be indented from a lateral side 200C of the housing 210 toward an inside of the electronic device 101. For example, the recess 410 may partially accommodate the key button 420. For example, the recess 410 may be formed such that the key button 420 is movable with respect to the housing 210, based on pressure exerted from the outside, by providing a free space in which the key button 420 is movable.

According to an embodiment, the housing 210 may include a first support portion 214 for supporting the key button 420. A head portion 421 of the key button 420 may be mounted on the first support portion 214. For example, the first support portion 214 may form the recess 410 of the housing 210. For example, by supporting the head portion 421, the first support portion 214 may reduce the head portion 421 from leaving the recess 410 by the pressure exerted to the key button 420.

According to an embodiment, the housing 210 may include a second support portion 215 forming a space S for accommodating the printed circuit board 350. For example, the second support portion 215 may support the printed circuit board 350 and/or electrical components (e.g., the actuator 430 or the sensor 450) disposed on the printed circuit board 350 and for providing various haptic feedback to the key button 420. For example, the space S formed by the second support portion 215 may be a space for accommodating a key button assembly 400 exemplarily illustrated and described in FIGS. 4B to 4D, but an embodiment is not limited thereto.

According to an embodiment, the housing 210 may include a through hole 415, connecting with the recess 410. For example, the through hole 415 may penetrate the first support portion 214 for mounting of the head portion 421. The through hole 415 may connect the recess 410 defined by the first support portion 214 and the space S formed by the second support portion 215. For example, the through hole 415 may be penetrated by a shaft portion 422 of the key button 420. The through hole 415 may at least partially accommodate the shaft portion 422. For example, the through hole 415 may include a first through hole 415a penetrated by a first shaft portion 422a, and a second through hole 415b penetrated by a second shaft portion 422b, but the embodiment is not limited thereto.

According to an embodiment, the key button 420 may include the head portion 421 partially disposed in the recess 410, and the shaft portion 422 extending from the head portion 421 toward the inside of the electronic device 101. For example, the head portion 421 may be partially inserted into the recess 410 of the housing 210. The head portion 421 may be at least partially exposed to an outside of the electronic device 101. For example, the head portion 421 may form a step with respect to the lateral side 200C of the housing 210, by partially protruding to an outside of the recess 410. For example, the head portion 421 may be mounted on the first support portion 214 that provides the recess 410 of the housing 210. The head portion 214 may be movably coupled to the first support portion 214.

For example, the shaft portion 422 may protrude from the head portion 421 toward the inside of the electronic device 101. The shaft portion 422 may be configured to be in contact with components (e.g., the actuator 430) inside the electronic device 101, by penetrating the through hole 415 connected to the recess 410 of the housing 210. For example, the shaft portion 422 may be partially disposed in the through hole 415. The shaft portion 422 may press the actuator 430 in contact with the shaft portion 422, based on the pressure exerted to the head portion 421. The shaft portion 422 may be configured to transmit the pressure exerted to the head portion 421 to the actuator 430 and/or the sensor 450 of the inside of the electronic device 101.

For example, the shaft portion 422 may include the first shaft portion 422a and the second shaft portion 422b extending from the head portion 421 and spaced apart from each other. For example, each of the first shaft portion 422a and the second shaft portion 422b may protrude from both ends of the head portion 421 toward the inside of the electronic device 101. For example, the first shaft portion 422a may be in contact with a first actuator 431 in the space S by extending from the head portion 421 to the space S of the housing 210 through the first through hole 415a. The second shaft portion 422b may be in contact with a second actuator 432 in the space S by extending from the head portion 421 to the space S through the second through hole 415b. However, the embodiment supported by the present disclosure is not limited thereto.

According to an embodiment, the key button 420 may include a hook portion 425 extending from the head portion 421. The hook portion 425 may be coupled to the housing 210 to prevent the key button 420 from leaving the recess 410 of the housing 210. For example, the hook portion 425 may be engaged with the first support portion 214 on which the head portion 421 of the key button 420 is mounted or fastened to the first support portion 214. For example, the hook portion 425 may be positioned between the shaft portions 422a and 422b. The hook portion 425 may reduce the key button 420 from leaving the recess 410 of the housing 210 by being coupled to the housing 210. However, the embodiment is not limited thereto, and the key button 420 and/or the housing 210 may include various fastening portions for reducing the key button 420 from leaving the recess 410.

According to an embodiment, the printed circuit board 350 may be disposed toward the key button 420 within the housing 210. The printed circuit board 350 may include a flexible printed circuit board (FPCB) and/or a rigid-flexible printed circuit board (RFPCB). For example, the printed circuit board 350 may be disposed in the space S formed by the second support portion 215 of the housing 210. The printed circuit board 350 may be disposed to face the first support portion 214 on which the key button 420 is mounted in the space S. For example, one or more electronic components (e.g., the actuator 430 or the sensor 450) capable of being linked with the key button 420 may be mounted on the printed circuit board 350. The printed circuit board 350 may be positioned around the key button 420 such that the one or more electronic components operate based on pressure applied to the key button 420. For example, the printed circuit board 350 may be disposed toward the through hole 415 such that the actuator 430 disposed on the printed circuit board 350 faces the shaft portion 422 passing through the through hole 415.

In the present disclosure, when an expression (e.g., "on", "at the top", "below", "at the bottom", or "next to") for a positional relationship between an element and another element is mentioned, it should be understood that unless an expression such as "rightly" or "directly" is used, one or more intervening elements may exist therebetween, and it should be noted that it does not limit an arrangement relationship therebetween. For example, when an element is referred to as being "on" another element, it may mean that there may be one or more intervening elements therebetween other than an element being attached to another, inseparably coupled, or formed inseparably. For example, in the present disclosure, "the actuator 430 disposed on the printed circuit board 350" may mean that one or more intervening elements (e.g., the support plate 470) may exist between the printed circuit board 350 and the actuator 430. For example, in the present disclosure, "the actuator 430 disposed on the printed circuit board 350" may mean "the actuator 430 disposed over the printed circuit board 350". For example, "the actuator 430 disposed on the printed circuit board 350" may mean "the actuator 430 facing the printed circuit board 350 and spaced apart from the printed circuit board 350". However, embodiments supported by the present disclosure are not limited thereto.

According to an embodiment, the actuator 430 may be disposed between the printed circuit board 350 and the key button 420. The actuator 430 may be configured to provide haptic feedback to the head portion 421 of the key button 420 based on pressure exerted by the shaft portion 422 of the key button 420. For example, the actuator 430 may be in contact with the shaft portion 422 that has passed through the through hole 415. As the head portion 421 of the key button 420 is pressed, the shaft portion 422 may press the actuator 430. The actuator 430 may be configured to vibrate, based on the pressure exerted by the shaft portion 422. The actuator 430 may provide haptic feedback to the head portion 421 connected to the shaft portion 422, by transmitting the vibration to the shaft portion 422 based on the pressure. For example, the actuator 430 may be configured to vibrate by generating mechanical displacement based on receiving an electrical signal. The actuator 430 may be referred to as a piezoelectric actuator in that it generates mechanical displacement based on an electrical signal, but the embodiments supported in the present disclosure are not limited thereto.

For example, the actuator 430 may include the first actuator 431 disposed toward the first shaft portion 422a, and the second actuator 432 spaced apart from the first actuator 431 and disposed toward the second shaft portion 422b. The first actuator 431 may be configured to provide haptic feedback to the head portion 421 through the first shaft portion 422a, based on pressure exerted by first shaft portion 422a. The second actuator 432 may be configured to provide haptic feedback to the head portion 422 through the second shaft portion 422b, based on pressure exerted by the second shaft portion 422b. For example, an internal structure of the electronic device 101 for providing haptic feedback to the key button 420 illustrated and described exemplarily in FIG. 4A and/or the key button assembly 400 illustrated and described exemplarily in FIGS. 4B to 4D may be referred to as two piezoelectric actuator systems in that each of them includes the actuators 431 and 432 configured to provide the haptic feedback, respectively, but the embodiment supported in the present disclosure is not limited thereto.

According to an embodiment, the actuator 430 may be required to provide various haptic feedback based on the pressure exerted from the shaft portion 422 of the key button 420 to meet a user's demand. For example, the actuator 430 may be required to provide respectively different haptic feedback according to magnitude of the pressure exerted from shaft portion 422. In order to provide various haptic feedback, the actuator 430 may be required to be electrically connected to the sensor 450 configured to detect the pressure and/or the printed circuit board 350 on which the sensor 450 is disposed. A structure for connecting the sensor 450 and/or the printed circuit board 350 and the actuator 430 for providing various haptic feedback of the actuator 430 will be described later.

According to an embodiment, the sensor 450 may be configured to detect the pressure exerted from shaft portion 422. The printed circuit board 350 may include a mounting portion 351 on which the sensor 450 is disposed, spaced apart from the actuator 430, and a connecting portion 352, extending from the mounting portion 351 to electrically connect the actuator 430 and the mounting portion 351. The connecting portion 352 may be deformable.

For example, the sensor 450 may be pressed by the shaft portion 422 to detect the pressure exerted from the shaft portion 422. The sensor 450 may be aligned with the shaft portion 422 to be pressed by the shaft portion 422. For example, when the key button 420 is viewed from above (e.g., viewed in a -x direction), the sensor 450 may overlap the shaft portion 422 of the key button 420. For example, the sensor 450 may be disposed at a position corresponding to the through hole 415 penetrated by the shaft portion 422 among the mounting portion 351 of the printed circuit board 350. For example, the sensor 450 may be disposed on the printed circuit board 350 such that a central axis of the sensor 450 corresponds to a central axis of the shaft portion 422, but the embodiment is not limited thereto. For example, the sensor 450 may be referred to as a pressure sensor or a piezoelectric sensor in that it is configured to detect the pressure, but the embodiment supported by the present disclosure is not limited.

For example, the sensor 450 may include a first sensor 451, and a second sensor 452, mounted on the mounting portion 351 of the printed circuit board 350 and spaced apart from each other. The first sensor 451 may be aligned with the first shaft portion 422a to be pressed by the first shaft portion 422a. The first sensor 451 may overlap the first actuator 431 when the first shaft portion 422a is viewed from above (e.g., when viewed in the -x direction). The second sensor 452 may be aligned with the second shaft portion 422b to be pressed by the second shaft portion 422a. The second sensor 452 may overlap the second actuator 432 when the second shaft portion 422a is viewed from above. However, the embodiment supported by the present disclosure is not limited thereto, and the electronic device 101 may include a plurality of sensors disposed on the printed circuit board 350 to detect pressure exerted by the key button 420.

For example, the mounting portion 351 of the printed circuit board 350 may be coupled with the sensor 450. The mounting portion 351 may be spaced apart from the actuator 430 (or a piezoelectric element 440) for vibration of the actuator 430. The mounting portion 351 may support the sensor 450 pressed by the shaft portion 422. For example, various electronic components for linking with the key button 420 in addition to the sensor 450 may be disposed on the mounting portion 351. The mounting portion 351 may have a substantially flat shape in the space S formed by the second support portion 215 of the housing 210, but the embodiment supported by the present disclosure is not limited thereto.

For example, the connecting portion 352 of the printed circuit board 350 may connect the mounting portion 351 and the actuator 430, by extending from the mounting portion 351. For example, the connecting portion 352 may extend from the mounting portion 351 to the actuator 430. For example, an end of the connecting portion 352 may be connected to the mounting portion 351, and another end of the connecting portion 352 may be connected to the actuator 430. However, the embodiment is not limited thereto, and the connecting portion 352 may be integrally formed with the mounting portion 351.

For example, the connecting portion 352 may be at least partially bent to connect the actuator 430 and the mounting portion 351 spaced apart from the actuator 430. For example, by being deformable, the connecting portion 352 may reduce a decrease in vibration performance of the actuator 430 connected to the connecting portion 352. For example, the connecting portion 352 may be configured to guide the vibration (or deformation) of the actuator 430 by being connected to a lateral side of the actuator 430, but the embodiment supported by the present disclosure is not limited thereto.

For example, the connecting portion 352 may include a first connecting portion 352a connecting the mounting portion 351 and the first actuator 431, and a second connecting portion 352b connecting the mounting portion 351 and the second actuator 432 spaced apart from the first actuator 431. The first actuator 431 may be configured to receive an electrical signal through the first connecting portion 352a. The second actuator 432 may be configured to receive an electrical signal through the second connecting portion 352b. However, the embodiment supported by the present disclosure is not limited thereto, and the printed circuit board 350 may include a plurality of connecting portions to connect the mounting portion 351 on which the sensor is mounted, and the actuator 430 spaced apart from the mounting portion 351.

According to an embodiment, the actuator 430 may include the piezoelectric element 440 that provides haptic feedback based on pressure exerted by the key button 420, and a vibration plate 460 coupled to the piezoelectric element 440 for amplification of vibration generated from the piezoelectric element 440. For example, the piezoelectric element 440 may include electrodes connected to the connecting portion 352 of the printed circuit board 350 in the actuator 430. The piezoelectric element 440 may generate the vibration, based on the electrical signal received from the connecting portion 352. For example, the vibration plate 460 may be configured to amplify the vibration generated from the piezoelectric element 440, by being attached to the piezoelectric element 440. The vibration plate 460 may amplify the vibration generated from the piezoelectric element 440 by spacing the piezoelectric element 440 apart from the printed circuit board 350 (and/or the support plate 470) and the shaft portion 422 of the key button 420.

For example, the first actuator 431 may include a first piezoelectric element 441 configured to vibrate based on pressure exerted by the first shaft portion 422a, a first vibration plate 461 disposed between the first piezoelectric element 441 and the first shaft portion 422a, and a second vibration plate 462 disposed between the first piezoelectric element 441 and the mounting portion 351 of the printed circuit board 350. The first piezoelectric element 441 may be connected to the first connecting portion 352a of the printed circuit board 350. The first vibration plate 461 and the second vibration plate 462 may provide haptic feedback to the head portion 421 by amplifying the vibration of the first piezoelectric element 441 vibrating based on the pressure exerted from the first shaft portion 422a. For example, the second actuator 432 may include a second piezoelectric element 442 configured to vibrate based on pressure exerted by the second shaft portion 422b, a third vibration plate 463 disposed between the second piezoelectric element 442 and the second shaft portion 422b, and a fourth vibration plate 464 disposed between the second piezoelectric element 442 and the mounting portion 351 of the printed circuit board 350. The second piezoelectric element 442 may be connected with the second connecting portion 352b of the printed circuit board 350. The third vibration plate 463 and the fourth vibration plate 464 may provide haptic feedback to the head portion 422 by amplifying vibration of the second piezoelectric element 442 vibrating based on pressure exerted from the second shaft portion 422b. However, the embodiment supported by the present disclosure are not limited thereto.

According to an embodiment, the actuator 430 may be disposed on a first surface 351a of the mounting portion 351 facing the key button 420 so as to be disposed toward the key button 420. For example, the sensor 450 may be disposed on a second surface 351b of the mounting portion 352 opposite to the first surface 351a. For example, the connecting portion 352 of the printed circuit board 350 may extend from a lateral side of the mounting portion 351 so as to connect the mounting portion 351 and the actuator 430.

For example, the mounting portion 351 of the printed circuit board 350 may be at least partially disposed between the actuator 430 and the sensor 450. The mounting portion 351 (and/or the support plate 470) may space the actuator 430 apart from the sensor 450. For example, the sensor 450 may be aligned with the shaft portion 422 to be pressed by the shaft portion 422. The actuator 430 may be aligned with the shaft portion 422 and the sensor 450 to be pressed by the shaft portion 422. For example, the first actuator 431 is aligned with the shaft portion 422a and the first sensor 451. The second actuator 432 may be aligned with the second shaft portion 422b and the second sensor 452. The actuator 430 and the sensor 450 may improve accuracy of pressure exerted from the shaft portion 422 measured by the sensor 450 while improving performance of haptic feedback transmitted to the head portion 421 through the shaft portion 422, by being aligned with the shaft portion 422 of the key button 420.

For example, the connecting portion 352 may extend from the lateral side of the mounting portion 351 on which the sensor 450 is disposed to the lateral side of the actuator 430, so as to connect the actuator 430 to the mounting portion 351 on which the sensor 450 is disposed. For example, the connecting portion 352 may be connected to a lateral side of the piezoelectric element 440 included in the actuator 430. For example, the first piezoelectric element 441 of the first actuator 431 may include a front surface 441a to which the first vibration plate 461 is attached, a rear surface 441b to which the second vibration plate 462 is attached, and a lateral side 441c extending from the front surface 441a to the rear surface 441b. The first connecting 352a may connect the mounting portion 351 and the lateral side 441c of the first piezoelectric element 441. The first connecting portion 352a may extend along the lateral side 441c of the first piezoelectric element 441. For example, the second piezoelectric element 442 of the second actuator 432 may include a front surface 442a to which the third vibration plate 463 is attached, a rear surface 442b to which the fourth vibration plate 464 is attached, and a lateral side 442c extending from the front surface 442a to the rear surface 442b. The second connecting portion 352b may connect the mounting portion 351 and the side surface 442c of the second piezoelectric element 442. The second connecting portion 352b may extend along the lateral side 442c of the second piezoelectric element 442. However, the embodiment supported by the present disclosure is not limited thereto.

The electronic device 101 may include a processor 120 connected to the sensor 450. Operations in the following description may be performed or caused by the electronic device 101 and/or the processor of the electronic device 101 (e.g., the processor 120 of FIG. 1), respectively. The processor 120 may be referred to as at least one processor or one or more processors, including processing circuitry in the electronic device 101. In addition, instructions stored in one or more storage media included in memory (e.g., the memory 130 of FIG. 1) in the electronic device 101 may cause the electronic device 101 to perform each of the operations described below, when executed individually or collectively by the processor 120.

For example, the processor 120 may identify pressure detected from the sensor 450. The processor 120 may transmit a signal corresponding to the pressure to the actuator 430 (or the piezoelectric element 440), based on the identified pressure. The actuator 430 may be configured to vibrate to provide haptic feedback corresponding to the signal, based on receiving the signal corresponding to the pressure. Through the vibration, the haptic feedback may be provided to the key button 420 (or the head portion 421). Since signals received to the actuator 430 are respectively different according to the pressure, the electronic device 101 may provide various haptic feedback according to the pressure through the key button 420.

The electronic device 101 may include the support plate 470 attached on the first surface 351a of the mounting portion 351 facing the key button 420 to support the actuator 430 pressed by the shaft portion 422. The sensor 450 may be disposed on the second surface 351b of the mounting portion 351 opposite to the first surface 351a. For example, the support plate 470 may be at least partially interposed between the mounting portion 351 and the actuator 430. The support plate 470 may support the actuator 430 pressed by the shaft portion 422. For example, the support plate 470 may support the actuator 430 in a direction (e.g., +x direction) opposite to a direction (e.g., -x direction) of force exerted by the shaft portion 422. For example, the support plate 470 may reduce damage to the mounting portion 351 due to the shaft portion 422 of the key button 420, by being attached to the first surface 351a of the mounting portion 351 facing the key button 420. For example, the support plate 470 may separate the mounting portion 35 and the actuator 430. The connecting portion 352 of the printed circuit board 350 may electrically connect the mounting portion 351 and the actuator 430, spaced apart by the support plate 470. However, the embodiment supported by the present disclosure is not limited to thereto, and the electronic device 101 may include rigid structures and/or stiffeners for supporting the actuator 430 and the mounting portion 351.

Referring to FIGS. 4B to 4D, the electronic device 101 may include a key button assembly 400 including the key button 420, the printed circuit board 350, the actuator 430, and the sensor 450. The key button assembly 400 may function as a key button module, but is not limited thereto. For example, the printed circuit board 350 may include a third connecting portion 352c connecting the key button assembly 400 and a printed circuit board (e.g., the first printed circuit board 250 of FIG. 2B, the main PCB) on which the processor 120 of the electronic device 101 is disposed.

According to an embodiment, the electronic device 101 may include a spacer 480 for supporting the mounting portion 351 of the printed circuit board 350 within the housing 210, and an elastic member 485 interposed between the spacer 480 and the mounting portion 351. For example, the spacer 480 may be mounted on the second support portion 215 of the housing 210. By being interposed between the second support portion 215 and the mounting portion 351 (or the key button assembly 400), the spacer 480 may be configured to closely contact the mounting portion 351 and/or the actuator 430 on the mounting portion 351 toward the key button 420. For example, the elastic member 485 may be disposed between the spacer 480 and the sensor 450. Since the elastic member 485 is deformable, the elastic member 485 may relieve an impact transmitted from the shaft portion 422 to the sensor 450, or may support the sensor 450. For example, the elastic member 485 may include a first elastic member 485a aligned with the first sensor 451, and a second elastic member 485b aligned with the second sensor 452, but the embodiment supported by the present disclosure is not limited.

According to an embodiment, the electronic device 101 may include a seal 490 surrounding a lateral side of the shaft portion 422. For example, by being fastened to the shaft portion 422, the seal 490 may be disposed in the through hole 415 in which the shaft portion 422 is positioned. By being interposed between the shaft portion 422 and an internal surface of the through hole 415, the seal 490 may separate the space S in which electronic components (e.g., the actuator 430, or the sensor 450) are disposed and the outside (or the recess 410) of the electronic device 101. By occupying the through hole 415 together with the shaft portion 422, the seal 490 may reduce an inflow of a foreign substance from the outside of the electronic device 101 into the space S in which the electronic components are disposed. For example, the seal 490 may include a first seal 491 disposed in the first through hole 415a with the first shaft portion 422a, and a second seal 492 disposed in the second through hole 415b with the second shaft portion 422b, but the embodiment supported by the present disclosure is not limited thereto.

According to the above-described embodiment, the electronic device 101 (or the key button assembly 400) may provide various user experiences to a user by including the sensor 450 for detecting pressure exerted by the key button 420 and the actuator 430 configured to provide various haptic feedback to the key button 420 according to the pressure. The electronic device 101 may improve performance of haptic feedback provided through the key button 420 while improving accuracy of the pressure exerted from the key button 420 measured by the sensor 450, by including the mounting portion 351 on which the sensor is disposed, spaced apart from the actuator 430, and the connecting portion 352 connecting the mounting portion 351 and the actuator 430.

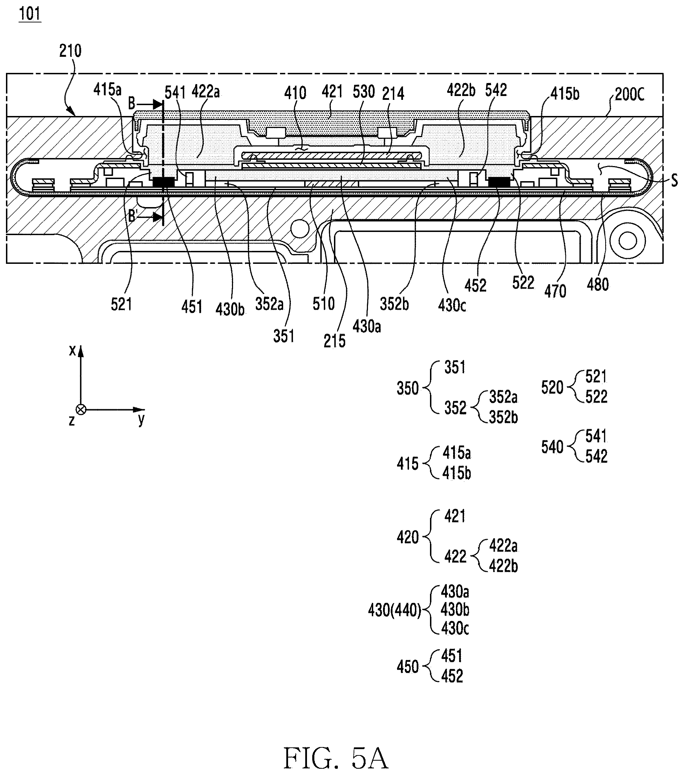

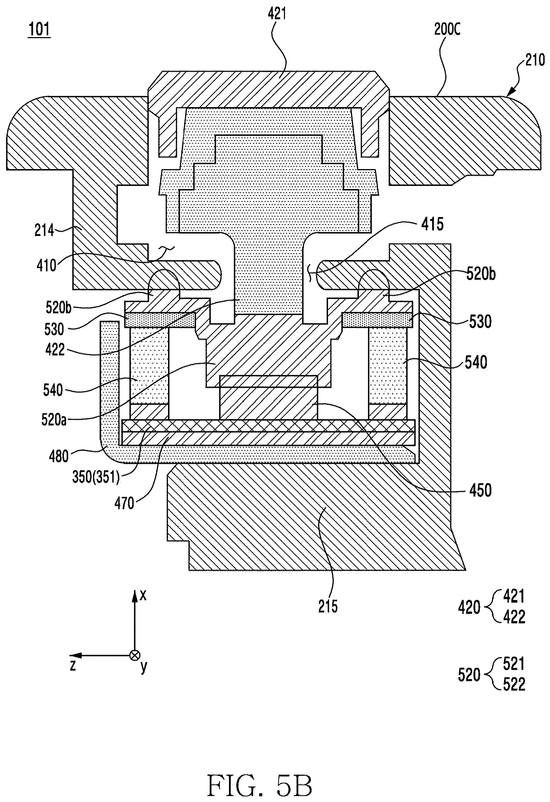

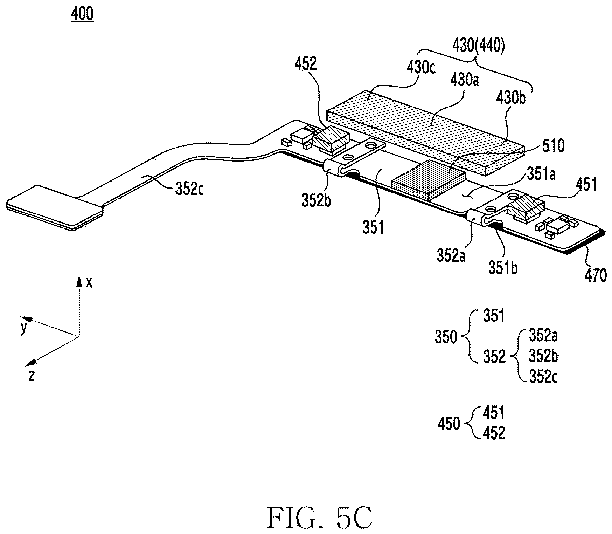

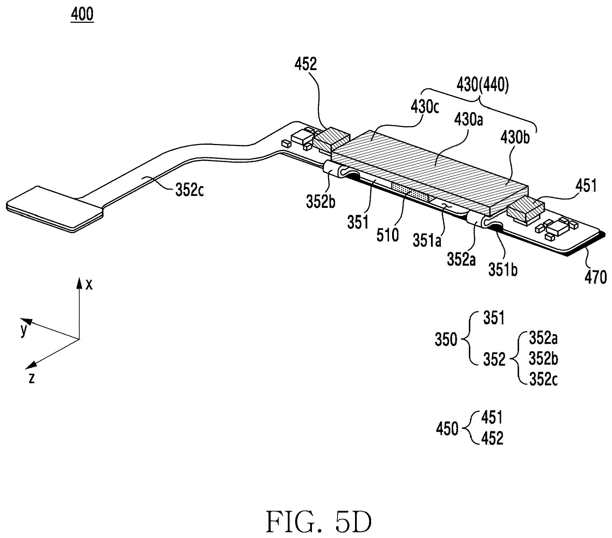

FIG. 5A is a partial cross-sectional view of an exemplary electronic device cut along line A-A' of FIG. 2A. FIG. 5B is a partial cross-sectional view of an exemplary electronic device cut along line B-B' of FIG. 5A. FIGS. 5C and 5D illustrate a key button assembly of an exemplary electronic device.

Referring to FIGS. 5A, 5B, and 5C, an electronic device 101 may comprise a housing 210 including a recess 410. The electronic device 101 may comprise a key button 420 including a head portion 421 partially disposed in the recess 410 and a shaft portion 422 extending from the head portion 421 toward an inside of the electronic device 101. The electronic device 101 may comprise a printed circuit board 350 disposed toward the key button 420 within the housing 210. The electronic device 101 may comprise an actuator 430 disposed between the printed circuit board 350 and the key button 420, configured to provide haptic feedback to the head portion 421 based on pressure exerted by the shaft portion 422. The electronic device 101 may comprise a sensor 450 configured to detect the pressure. The printed circuit board 350 may include a mounting portion 351 on which the sensor 450 is disposed, spaced apart from the actuator 430, and a connecting portion 352 , which is deformable, extending from the mounting portion 351 to electrically connect the actuator 430 and the mounting portion 351. However, an embodiment supported by the present disclosure is not limited thereto, and the electronic device 101 exemplarily illustrated and described in FIGS. 5A to 5D may include the configurations (e.g., the hook portion 425, the elastic member 485, or the seal 490) exemplarily illustrated and described in FIGS. 4A to 4D. In addition, an overlapping description of a configuration with the same reference numerals exemplarily described in FIGS. 4A to 4D are omitted below to the extent that examples contradict or do not conflict each other.

Referring to FIGS. 5A to 5D, unlike FIGS. 4A to 4D, the electronic device 101 (or the key button assembly 400) may include the actuator 430 configured to provide haptic feedback through the key button 420. For example, an internal structure of the electronic device 101 for providing the haptic feedback to the key button 420 illustrated and described exemplarily in FIGS. 5A to 5D and/or the key button assembly 400 illustrated and described exemplarily in FIGS. 5C to 5D may be referred to as a one piezoelectric actuator system in that each of them includes the actuator 430 (or the piezoelectric element) configured to provide the haptic feedback, but the embodiment supported in the present disclosure is not limited thereto.

Unlike exemplarily illustrated and described in FIGS. 4A to 4D, the actuator 430 and the sensor 450 may be disposed on a first surface 351a facing the key button 420 of the mounting portion 351, respectively. For example, a first sensor 451, a second sensor 452, and the actuator 430 may be coupled on the first surface 351a of the mounting portion 351. Unlike FIGS. 4A to 4D, a support plate 470 for supporting the mounting portion 351 may be attached to a second surface 351b opposite to the first surface 351a. For example, the support plate 470 may be disposed between the mounting portion 351 and the spacer 480. For example, the actuator 430 may be disposed between the first sensor 451 and the second sensor 452, but the embodiment is not limited thereto.

According to an embodiment, the electronic device 101 may include a support member 510 interposed between the mounting portion 351 of the printed circuit board 350 and the actuator 430 to support the actuator 430. For example, the support member 510 may be disposed between the first surface 351a of the mounting portion 351 and the actuator 430. By supporting the actuator 430, the support member 510 may guide a position of the actuator 430 such that the actuator 430 is pressed by the shaft portion 422 of the key button 420. For example, the support member 510 may be a rigid body (e.g., metal) with relatively greater rigidity than the actuator 430, but the embodiment is not limited thereto.

According to an embodiment, the connecting portion 352 may be configured to be folded back on itself on the first surface 351a to extend from the mounting portion 351 to the actuator 430 disposed on the first surface 351a of the mounting portion 351. For example, the first connecting portion 352a may be connected to a second portion 430b of the actuator 430. By being bent on the first surface 351a of the mounting portion 351, the first connecting portion 352a may connect the mounting portion 351 and the second portion 430b spaced apart from the mounting portion 351 by the support member 510. The second connecting portion 352b may be connected to a third portion 430c of the actuator 430. By being bent on the first surface 351a of the mounting portion 351, the second connecting portion 352b may connect the mounting portion 351 and the third portion 430c spaced apart from the mounting portion 351 by the support member 510. For example, the connecting portion 352 may guide the portions 430b and 430c that form both ends of the actuator 430 to generate displacement, by being deformable, but the embodiment supported by the present disclosure is not limited thereto.

According to an embodiment, the actuator 430 may comprise the first portion 430a attached on the support member 510, the second portion 430b, deformable by being pressed by the first shaft portion 422a, and the third portion 430c, deformable by being pressed by the second shaft portion 422a. The second portion 430b may form an end of the actuator 430. The third portion 430c may form another end opposite to the end of the actuator 430.

For example, the first portion 430a may be a portion supported by the support member 510. The first portion 430a may overlap the support member 510. Since the first portion 430a is supported by the support member 510, displacement may be fixed with respect to pressure exerted by the shaft portion 422. For example, the second portion 430b may be configured to generate the displacement, based on pressure exerted by the first shaft portion 422a. The second portion 430b may be pressed by the first shaft portion 422a together with the first sensor 451. Based on pressure detected from the first sensor 451, the second portion 430b may provide haptic feedback to the head portion 421 through the first shaft portion 422a. For example, the third portion 430c may be configured to generate displacement based on pressure exerted by the second shaft portion 422b. The third portion 430c may be pressed by the second shaft portion 422b together with the second sensor 452. Based on pressure detected from the second sensor 452, the third portion 430c may provide haptic feedback to the head portion 421 through the second shaft portion 422b. However, the embodiment supported by the present disclosure is not limited thereto.

For example, the first connecting portion 352a may be pressed together with the second portion 430b of the actuator 430 connected to the first connecting portion 352a by the first shaft portion 422a, and the first sensor 451 disposed around the first connecting portion 352a. The actuator 430 may receive a signal for haptic feedback corresponding to the pressure, through the first connecting portion 352a, based on the pressure detected through the first sensor 451. Based on the received signal, the actuator 430 may provide the haptic feedback corresponding to the pressure. While the actuator 430 provides the haptic feedback, the first connecting portion 352a may be coupled to the second portion 430b such that the second portion 430b of the actuator 430 generates displacement, by being deformable. For example, the second connecting portion 352b may be pressed together with the third portion 430c of the actuator 430 connected to the second connecting portion 352b by the second shaft portion 422b, and the second sensor 452 disposed around the second connecting portion 352b. The actuator 430 may receive a signal for haptic feedback corresponding to the pressure, through the second connecting portion 352b, based on the pressure detected through the second sensor 452. Based on the received signal, the actuator 430 may provide the haptic feedback corresponding to the pressure. While the actuator 430 provides the haptic feedback, the second connecting portion 352b may be coupled to the third portion 430c such that the third portion 430c of the actuator 430 generates displacement, by being deformable. However, the embodiment supported by the present disclosure is not limited thereto.

According to an embodiment, the electronic device 101 may include a waterproof member 520 covering a through hole 415, connecting with the recess of the housing 210, penetrated by the shaft portion 422 to isolate the inside of the electronic device 101 and an outside of the electronic device 101. The waterproof member 520 may be configured to be in contact with the portions 430b and 430c that generate displacement of the sensor 450 and the actuator 430 by the shaft portion 422. For example, the waterproof member 520 may cover the through hole 415 in a space S formed by a second support portion 215 of the housing 210. The waterproof member 520 may separate the space S in which electronic components (e.g., the actuator 430, or the sensor 450) are disposed and the outside (or the recess 410) of the electronic device 101. By covering the through hole 415, the waterproof member 520 may reduce an inflow of a foreign substance from the outside of the electronic device 101 into the space S in which the electronic components are disposed. For example, the waterproof member 520 may include a first waterproof member 521 configured to cover a first through hole 415a and be pressed by the first shaft portion 422a, and a second waterproof member 522 configured to cover a second through hole 415b and be pressed by the second shaft portion 422b, but the embodiment supported by the present disclosure is not limited thereto.

According to an embodiment, the electronic device 101 may include a support structure 530 supporting the waterproof member 520 to prevent the waterproof member 520 from leaving the through hole 415. The support structure 530 may be coupled on the first surface 351a of the mounting portion 351. For example, the support structure 530 may surround the actuator 430 and/or the sensor 450. For example, the support structure 530 may be disposed between the mounting portion 351 and the waterproof member 520. The support structure 530 may include a hole for passing through the waterproof member 520 (or the shaft portion 422).

According to an embodiment, the electronic device 101 may comprise a guide member 540 disposed between the mounting portion 351 of the printed circuit board 350 and the waterproof member 520. To limit a moving range of the shaft portion 422 in a first direction (e.g., a -x direction) from the head portion 421 of the key button 420 toward the inside of the electronic device 101, the guide member 540 may be configured to support the waterproof member 520 such that force is provided to the waterproof member 520 in a second direction (e.g., a +x direction) opposite to the first direction. For example, the guide member 540 may be disposed on the first surface 351a of the mounting portion 351. For example, the guide member 540 may be disposed between the mounting portion 351 and the waterproof member 520 (and/or the support structure 530). For example, the guide member 540 may include a first guide member 541 for supporting the first waterproof member 521, and a second guide member 542 for supporting the second waterproof member 522, but the embodiment is not limited thereto.

For example, referring to FIG. 5B, the waterproof member 520 may include a first waterproof portion 520a configured to be pressed by the shaft portion 422, and a second waterproof portion 520b connected to the first waterproof portion 520a and supported by the support structure 530. The first waterproof portion 520a may be in contact with the shaft portion 422. The first waterproof portion 520a may be in contact with the sensor 450 and the actuator 430 on the mounting portion 351. The first waterproof portion 520a may press the sensor 450 and the actuator 430 by being pressed by the shaft portion 422. For example, the second waterproof portion 520b may seal a periphery of the through hole 415 formed in the first support portion 214 by being in contact with the first support portion 214 of the housing 210 forming the recess 410. For example, the second waterproof portion 520b may be in close contact with the first support portion 214 by being supported by the support structure 530.

For example, the guide member 540 may support the second waterproof portion 520b (or the support structure 530). For example, the first waterproof portion 520a may be moved or deformed in the first direction (e.g., the -x direction) by the shaft portion 422, by being pressed by the shaft portion 422. The second waterproof portion 520b connected to the first waterproof portion 520a may receive force in the first direction by the shaft portion 422. The support structure 530 and/or the guide member 540 may reduce leaving the second waterproof portion 520b from the periphery of the through hole 415 by the shaft portion 422, by supporting the second waterproof portion 520b in the second direction (e.g., the +x direction) opposite to the first direction.

According to the above-described embodiment, the electronic device 101 (or the key button assembly 400) may provide various user experiences to a user, by including the sensor 450 for detecting pressure exerted by the key button 420 and the actuator 430 configured to provide various haptic feedback to the key button 420 according to the pressure. The electronic device 101 may improve performance of haptic feedback provided through the key button 420 while improving accuracy of the pressure exerted from the key button 420 measured by the sensor 450, by including the mounting portion 351 on which the sensor is disposed, spaced apart from the actuator 430, and the connecting portion 352 connecting the mounting portion 351 and the actuator 430.

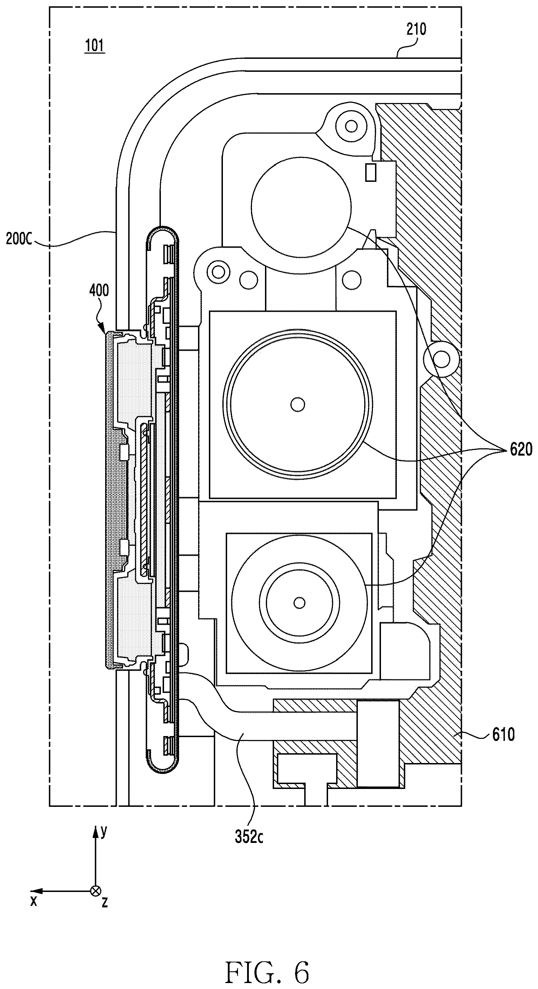

FIG. 6 illustrates an internal structure of an exemplary electronic device in which a key button assembly is disposed.

Referring to FIG. 6, the key button assembly 400 exemplarily illustrated and described in FIGS. 5A to 5D may be disposed in the electronic device 101. For example, the key button assembly 400 may include configurations (e.g., the key button 420, the printed circuit board 350, the actuator 430, or the sensor 450) exemplarily described in FIGS. 5A to 5D. For example, the key button assembly 400 may be disposed toward a lateral side 200C of a housing 210. For example, the key button 420 of the key button assembly 400 may be partially exposed to an outside of the electronic device 101 through the lateral side 200C.

Unlike the key button assembly 400 exemplarily illustrated and described in FIGS. 4A to 4D, in the key button assembly 400 exemplarily illustrated and described in FIGS. 5A to 5D, a vibration plate 460 of the actuator 430 may be omitted. The key button assembly 400 may include a support member (e.g., the support member 510 of FIG. 5A) for supporting the actuator 430 (or the piezoelectric element 440). The key button assembly 400 may reduce an entire thickness of the key button assembly 400 by including the support member 510 for supporting the actuator 430 instead of the vibration plate 460. In addition, unlike the key button assembly 400 exemplarily illustrated and described in FIGS. 4A to 4D, the key button assembly 400 may reduce the entire thickness of the key button assembly 400, by both the sensor 450 and the actuator 430 being disposing on a first surface (e.g., the first surface 351a of FIG. 4B) of a support portion (e.g., the support portion 351 of FIG. 4A) of the printed circuit board 350 facing the key button 420.

According to an embodiment, the key button assembly 400 may be disposed around a plurality of cameras 620 (or a camera module) in the electronic device 101. The key button assembly 400 may provide an additional space for disposing the plurality of cameras 620, by having a relatively small thickness. For example, the key button assembly 400 may be disposed along the plurality of cameras 620. For example, the key button assembly 400 may be spaced apart from each other by a second support portion (e.g., the second support portion 215 of FIG. 4A) of the housing 210 for supporting the key button assembly 400, but an embodiment is not limited thereto.

According to an embodiment, the printed circuit board 350 of the key button assembly 400 may include a third connecting portion 352c connecting the mounting portion 351 of the printed circuit board 350 and another printed circuit board 610 (e.g., the first printed circuit board 250 of FIG. 2B, the main PCB) on which a processor (e.g., the processor 120 of FIG. 1) in the electronic device 101 is mounted. The actuator 430 connected to the another printed circuit board through the third connecting portion 352c may receive a signal related to haptic feedback from the processor 120.

According to the above-described embodiment, the key button assembly 400 may reduce the entire thickness of the key button assembly 400, by including the actuator 430 configured to provide the haptic feedback to the key button 420. By having a relatively thin thickness, the key button assembly 400 may provide an additional space for electronic components (e.g., the plurality of cameras 620) of the electronic device 101 disposed around the key button assembly 400.

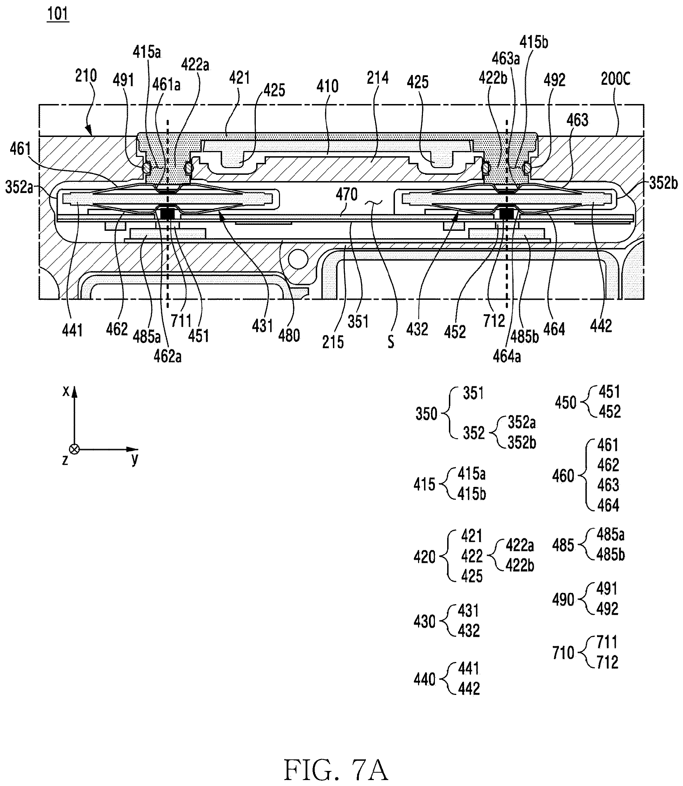

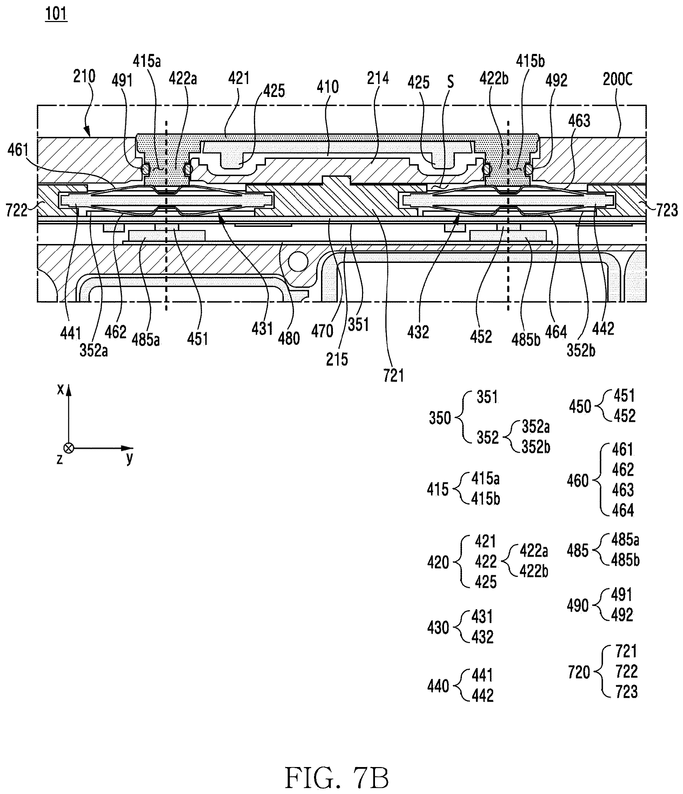

FIG. 7A and 7B illustrate an internal structure of an exemplary electronic device.

Referring to FIGS. 7A and 7B, an electronic device 101 may comprise a housing 210 including a recess 410. The electronic device 101 may comprise a key button 420 including a head portion 421 partially disposed in the recess 410 and a shaft portion 422 extending from the head portion 421 toward an inside of the electronic device 101. The electronic device 101 may comprise a printed circuit board 350 disposed toward the key button 420 within the housing 210. The electronic device 101 may comprise an actuator 430 disposed between the printed circuit board 350 and the key button 420, configured to provide haptic feedback to the head portion 421 based on pressure exerted by the shaft portion 422. The electronic device 101 may comprise a sensor 450 configured to detect the pressure. The printed circuit board 350 may include a mounting portion 351 on which the sensor 450 is disposed, spaced apart from the actuator 430, and a connecting portion 352, which is deformable, extending from the mounting portion 351 to electrically connect the actuator 430 and the mounting portion 351. However, an embodiment supported by this disclosure is not limited, and the electronic device 101 exemplarily illustrated and described in FIGS. 7A and 7B may include the configurations exemplarily illustrated and described in FIGS. 4A to 4D. In addition, an overlapping description of a configuration with the same reference numerals exemplarily described in FIGS. 4A to 4D are omitted below to the extent that examples contradict or do not conflict each other.

As the actuator 430 vibrates to provide the haptic feedback, in the electronic device 101, a structure for securing a position of the actuator 430 for stable provision of the haptic feedback may be required. For example, in order to provide the haptic feedback to the head portion 421 through a first shaft portion 422a, a first actuator 431 may be required to be aligned with the first shaft portion 422a. In order to provide the haptic feedback to the head portion 421 through a second shaft portion 422b, a second actuator 432 may be required to be aligned with the second shaft portion 422b. A structure for securing and/or guiding the position of the actuator 430 of the electronic device 101 (or the key button assembly 400 of FIG. 4B) is illustrated through an illustration and a description of FIGS. 7A and 7B.

Referring to FIG. 7A, in an embodiment, a vibration plate 460 of the actuator 430 may include a guide groove dented toward a piezoelectric element 440 of the actuator 430. The electronic device 101 may include a first guide structure 710, attached on the mounting portion 351, protruding into an inside of the guide groove. The first guide structure 710 may be aligned with the actuator 430, the shaft portion 422, and the sensor 450 to guide the position of the actuator 430, but an embodiment supported by the present disclosure is not limited thereto.

For example, the first actuator 431 may include a first vibration plate 461 including a first guide groove 461a dented toward a surface (e.g., the front surface 441a of FIG. 4B) of a first piezoelectric element 441, and a second vibration plate 462 including a second guide groove 462a dented toward another surface (e.g., the rear surface 441b of FIG. 4B) opposite to the surface of the first piezoelectric element 441. For example, the second actuator 432 may include a third vibration plate 463 including a third guide groove 463a dented toward a surface (e.g., the front surface 442a of FIG. 4B) of a second piezoelectric element 442, and a fourth vibration plate 464 including a fourth guide groove 464a dented toward another surface (e.g., the rear surface 442b of FIG. 4B) opposite to the surface of the second piezoelectric element 442. For example, the first guide structure 710 may include a first guide portion 711 protruding from the first surface 351a of the mounting portion 351 to an inside of the second guide groove 462a of the second vibration plate 462, and a second guide portion 712 protruding from the first surface 351a to an inside of the fourth guide groove 464a of the fourth vibration plate 464. The first guide portion 711 may secure a position of the first actuator 431, while the first actuator 431 provides the haptic feedback, by being fastened in the second guide groove 462a. The second guide portion 712 may secure a position of the second actuator 432, while the second actuator 432 provides the haptic feedback, by being fastened in the fourth guide groove 464a. However, the embodiment is not limited thereto.

For example, although not illustrated, the shaft portion 422 may include a protrusion (not illustrated) for securing the position of the actuator 430 together with the first guide structure 710. For example, the first shaft portion 422a may include a protrusion configured to secure the position of the first actuator 431 together with the first guide portion 711 by protruding into an inside of the first guide groove 461a of the first vibration plate 461. For example, the second shaft portion 422b may include a protrusion configured to secure the position of the second actuator 432 together with the second guide portion 712 by protruding into an inside of the third guide groove 463a of the third vibration plate 463. However, the embodiment supported by the present disclosure is not limited thereto.

Referring to FIG. 7B, in an embodiment, the electronic device 101 may include a second guide structure 720 for securing a position of the actuator 430. For example, the second guide structure 720 may secure the position of the actuator 430 by occupying a space S. For example, the second guide structure 720 may include a third guide portion 721 disposed between the first actuator 431 and the second actuator 432, a fourth guide portion 722 securing the position of the first actuator 431 with the third guide portion 721, and a fifth guide portion 723 securing the position of the second actuator 432 with the third guide portion 721. For example, the third guide portion 721 may be interposed between the support plate 470 supporting the actuator 430 and a first support portion 214 of the housing 210 on which the head portion 421 is mounted. For example, the third guide portion 721 and the fourth guide portion 722 may secure the position of the first actuator 431 while the first actuator 431 provides haptic feedback, by being coupled to both ends of the first piezoelectric element 441, respectively. The third guide portion 721 and the fifth guide portion 723 may secure the position of the second actuator 432 while the second actuator 432 provides haptic feedback, by being coupled to both ends of the second piezoelectric element 442, respectively. However, the embodiment supported by the present disclosure is not limited, and the electronic device 101 (or the key button assembly 400) may include various guide structures for aligning the actuator 430 with the shaft portion 422 (and/or the sensor 450).

According to the above-described embodiment, the electronic device 101 may improve performance of the haptic feedback provided through the key button 420 from the actuator 430, by including the guide structures 710 and 720 for securing the position of the actuator 430 while the actuator 430 provides the haptic feedback.

As described above, an electronic device (e.g., the electronic device 101 of FIG. 1) may comprise a housing (e.g., the housing 210 of FIG. 2A) including a recess (e.g., the recess 410 of FIG. 4A). The electronic device may comprise a key button (e.g., the one or more key buttons 320 of FIG. 3 and the key button 420 of FIG. 4A) including a head portion (e.g., the head portion 421 of FIG. 4A) partially disposed in the recess, and a shaft portion (e.g., the shaft portion 422 of FIG. 4A, the first shaft portion 422a, or the second shaft portion 422b) extending from the head portion toward an inside of the electronic device. The electronic device may comprise a printed circuit board (e.g., the printed circuit board 350 of FIG. 3) disposed toward the key button within the housing. The electronic device may comprise an actuator (e.g., the actuator 430, the first actuator 431, or the second actuator 432), disposed between the printed circuit board and the key button, configured to provide haptic feedback to the head portion based on pressure exerted by the shaft portion. The electronic device may comprise a sensor (e.g., the sensor 450 of FIG. 4A, the first sensor 451, or the second sensor 452) configured to detect the pressure. The printed circuit board may include a mounting portion (e.g., the mounting portion 351 of FIG. 4A), on which the sensor is disposed, spaced apart from the actuator, and a connecting portion (e.g., the connecting portion 352 of FIG. 4A, the first connecting portion 352a, or the second connecting portion 352b), which is deformable, extending from the mounting portion to electrically connect the actuator and the mounting portion.

The recess may comprise a hole formed in an outer shell of the housing, such that the key button can sit within the hole and extend into an interior of the electronic device.

The key button may comprise an outer portion which is at least partially disposed in the recess, and an inner portion which extends from the outer portion into the interior of the device.

The PCB may be disposed toward the key button such that applying pressure to an outer surface of the key button moves the key button towards the PCB.

The actuator may be configured so that when the actuator is activated it drives movement of the key button away from the PCB. The actuator may be configured so that when the actuator is activated it drives movement of the key button in an outwards direction. The actuator may be configured so that when the actuator is activated it drives movement of the key button in an alternating pattern. The actuator may be configured to provide a vibration of the key button.

The sensor may be a switch which is activated when a force greater than a threshold force is applied to the sensor. Alternatively, the sensor may configured to detect a degree of the force which is applied to the sensor and provide a measurement of the same.

For example, the sensor may be aligned with the shaft portion to be pressed by the shaft portion.

For example, the electronic device may further include a support member (e.g., the support member 510 of FIG. 5A) interposed between the mounting portion of the printed circuit board and the actuator to support the actuator. The actuator may include a first portion (e.g., the first portion 430a of FIG. 5A) attached on the support member, and a second portion (e.g., the second portion 430b of FIG. 5A), connecting with the connecting portion of the printed circuit board, configured to be deformed based on the pressure.

For example, the housing may further include a through hole (e.g., the one or more holes 310 of FIG. 3 and the through hole 415 of FIG. 4A), connecting with the recess, penetrated by the shaft portion. The electronic device may further comprise a waterproof member (e.g., the waterproof member 520 of FIG. 5A), covering the through hole to isolate the inside and an outside of the electronic device, configured to be in contact with the sensor and the second portion of the actuator by the shaft portion.

For example, the electronic device may further comprise a guide member (e.g., the guide member 540 of FIG. 5A) disposed between the mounting portion of the printed circuit board and the waterproof member. To limit a moving range of the shaft portion in a first direction from the head portion toward the inside of the electronic device, the guide member may be configured to support the waterproof member such that force is provided to the waterproof member in a second direction opposite to the first direction.

For example, the actuator may face a surface (e.g., the first surface 451a of FIG. 4A) of the mounting portion on which the sensor is coupled. The connecting portion may be folded back on itself on the surface of the mounting portion to extend from the mounting portion to the actuator.

For example, the key button may further include another shaft portion (e.g., the second shaft portion 422b of FIG. 4A), extending from the head portion toward the inside of the electronic device, spaced apart from the shaft portion (e.g., the first shaft portion 422a of FIG. 4A). The actuator may be positioned between the shaft portion and the another shaft portion to provide the haptic feedback to the head portion based on pressure exerted by the another shaft portion. The electronic device may further comprise another sensor (e.g., the second sensor 452 of FIG. 4A) disposed on the mounting portion to detect the pressure exerted by the another shaft portion.

For example, the actuator may be aligned with the shaft portion and the sensor to be pressed by the shaft portion.

For example, the electronic device may further comprise a support plate attached on a surface of the mounting portion toward the key button to support the actuator pressed by the shaft portion. The sensor may be attached on another surface (e.g., the second surface 451b of FIG. 4A) of the mounting portion opposite to the surface.

For example, the actuator may include a piezoelectric element (e.g., the piezoelectric element 440 of FIG. 4A) providing the haptic feedback based on the pressure, and a vibration plate (e.g., the vibration plate 460 of FIG. 4A), coupled to the piezoelectric element to space the piezoelectric element apart from the support plate, deformable based on the pressure. The connecting portion may connect the mounting portion and a lateral side (e.g., the lateral side 441c and the lateral side 442c of FIG. 4A) of the piezoelectric element which is spaced apart from the support plate by the vibration plate.

For example, the vibration plate may include a guide groove (e.g., the guide grooves 462a and 464a of FIG. 7A) dented toward the piezoelectric element. The electronic device may comprise a first guide structure (e.g., the first guide structure 710 of FIG. 7A), attached on the surface of the mounting portion, protruding into an inside of the guide groove.

For example, the key button may further include another shaft portion, extending from the head portion toward the inside of the electronic device, spaced apart from the shaft portion. The electronic device may further comprise another actuator (e.g., the second actuator 432 of FIG. 4A), disposed between the key button and the printed circuit board, configured to provide the haptic feedback to the head portion based on pressure exerted by the another shaft portion, and spaced apart from the actuator (e.g., the first actuator 431 of FIG. 4A). The electronic device may further comprise another sensor (e.g., the second sensor 452 of FIG. 4A) disposed on the mounting portion to detect the pressure exerted by the another shaft portion.

For example, a second guide structure (e.g., the second guide structure 720 of FIG. 7B) disposed between the actuator and the another actuator may be further comprised.

For example, the key button may further include a hook portion (e.g., the hook portion 425 of FIG. 4A) extending from the head portion. The hook portion may be coupled to the housing to prevent the key button from leaving the recess of the housing.

For example, the housing may further comprise a second support portion (e.g., the second support portion 215 of FIG. 4A) forming a space S to accommodate the printed circuit board. The electronic device may further comprise a spacer (e.g., the spacer 480 of FIG. 4A) mounted on the second support plate, and an elastic member (e.g., the elastic member 485 of FIG. 4A) interposed between the plate and the mounting portion of the printed circuit board.

As described above, an electronic device may comprise a housing including a recess, and first through hole (e.g., the first through hole 415a of FIG. 4A) and second through hole (e.g., the second through hole 415b of FIG. 4A), connecting with the recess, spaced apart from each other. The electronic device may comprise a key button including a head portion partially accommodated in the recess, a first shaft portion (e.g., the first shaft portion 422a of FIG. 4A) extending from the head portion toward an inside of the electronic device through the first through hole, and a second shaft portion (e.g., the second shaft portion 422b of FIG. 4A) extending from the head portion toward the inside through the second through hole. The electronic device may comprise a printed circuit board disposed toward the key button within the housing. The electronic device may comprise an actuator, disposed between the printed circuit board and the key button, configured to provide haptic feedback to the head portion based on pressure exerted by the key button. The electronic device may comprise at least one sensor (e.g., the sensor 450 of FIG. 4A) configured to detect the pressure. The printed circuit board may include a mounting portion, on which the at least one sensor is disposed, spaced apart from the actuator, and a connecting portion, which is deformable, extending from the mounting portion to electrically connect the actuator and the mounting portion.

For example, the at least one sensor may include a first sensor (e.g., the first sensor 451 of FIG. 4A) aligned with the first shaft portion to be pressed by the first shaft portion, and a second sensor (e.g., the second sensor 452 of FIG. 4A) aligned with the second shaft portion to be pressed by the second shaft portion. The actuator may be positioned between the first shaft portion and the second shaft portion.

For example, the electronic device may further comprise a support member interposed between the mounting portion of the printed circuit board and the actuator to support the actuator. The actuator may include a first portion attached on the support member, a second portion, deformable by being pressed by the first shaft portion, forming an end of the actuator, and a third portion, deformable by being pressed by the second shaft portion, forming another end opposite to the end of the actuator.

For example, the actuator may be aligned with the first shaft portion to be pressed by the first shaft portion. The electronic device may further comprise another actuator aligned with the second shaft portion to be pressed by the second shaft portion.

For example, the connecting portion of the printed circuit board may be at least partially bent.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An electronic device comprises a housing including a recess. The electronic device comprises a key button, the key button including an outer portion which is at least partially disposed in the recess, and a first inner portion extending from the outer portion toward an inside of the electronic device. The electronic device comprises a first member on which a first sensor is disposed. The electronic device comprises a first actuator which is disposed between the first sensor and the first inner portion of the key button. The first sensor is arranged to detect pressure. The key button and the first actuator are arranged to move with respect to the first member, so that a force applied on the outer portion of the key button is translated into a force applied on the first sensor by the first actuator.

The first actuator may be arranged to drive a motion of the key button when it is actuated. The first actuator may be arranged to provide haptic feedback to the key button. The first actuator may provide haptic feedback to the key button according to a pressure detected by the first sensor.

The first inner portion of the key button may be substantially cylindrical. The first actuator and the first sensor may be arranged along a longitudinal axis of the first inner portion.

The first member may be a printed circuit board. The first member may comprise at least one connecting portion, which is deformable, and which provides an electrical connection between the first member and the first actuator.

The key button may comprise a second inner portion, extending from the outer portion toward an inside of the electronic device. The electronic device may comprise a second sensor which is arranged to detect pressure and which is disposed on the first member. The electronic device may comprise a second actuator which is disposed between the second sensor and the second inner portion of the key button. The key button and the second actuator are arranged to move with respect to the first member, so that a force applied on the outer portion of the key button may be translated into a force applied on the first sensor by the first actuator.

The second actuator may be arranged to drive a motion of the key button when it is actuated. The second actuator may be arranged to provide haptic feedback to the key button. The first and second actuators may provide haptic feedback to the key button according to a pressure detected by the first and second sensors.

The second inner portion of the key button may be substantially cylindrical. The second actuator and the second sensor may be arranged along a longitudinal axis of the first inner portion.

The first member may comprise at least one connecting portion, which is deformable, and which provides an electrical connection between the first member and the second actuator.

The electronic device may further comprise a support member, the support member being located between the first inner portion of the key button and the second inner portion of the key button. The outer portion of the key button may rest upon the support member so that when an area of the key button over the first inner portion is pushed towards the first member, the area of the key button over the second inner portion will move away from the first member, and when an area of the key button over the second inner portion is pushed towards the first member, the area of the key button over the first inner portion will move away from the first member.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. An electronic device comprising:
a housing including a recess;
a key button including a head portion partially disposed in the recess, and a shaft portion extending from the head portion toward an inside of the electronic device;
a printed circuit board, PCB, disposed toward the key button within the housing;
an actuator, disposed between the PCB and the key button, configured to provide haptic feedback to the head portion based on pressure exerted by the shaft portion; and
a sensor configured to detect the pressure,
wherein the PCB includes:
a mounting portion, on which the sensor is disposed, spaced apart from the actuator; and
a connecting portion, which is deformable, extending from the mounting portion to electrically connect the actuator and the mounting portion.

2. The electronic device of claim 1,
wherein the sensor is aligned with the shaft portion to be pressed by the shaft portion.

3. The electronic device of claim 1 or claim 2, further includes:
a support member interposed between the mounting portion of the PCB and the actuator to support the actuator,
wherein the actuator includes:
a first portion attached on the support member; and
a second portion, connecting with the connecting portion of the PCB, configured to be deformed based on the pressure.

4. The electronic device of claim 3,
wherein the housing further includes:
a through hole, connecting with the recess, penetrated by the shaft portion, and
wherein the electronic device further comprising:
a waterproof member, covering the through hole to isolate the inside and an outside of the electronic device, configured to be in contact with the sensor and the second portion of the actuator by the shaft portion.

5. The electronic device of claim 4 further comprising:
a guide member disposed between the mounting portion of the PCB and the waterproof member, and
wherein the guide member is configured to support the waterproof member such that force is provided to the waterproof member in a second direction opposite to the first direction to limit a moving range of the shaft portion in a first direction from the head portion toward the inside of the electronic device.

6. The electronic device of any one of claims 1 to 5,
wherein the actuator faces a surface of the mounting portion on which the sensor is coupled, and
wherein the connecting portion is folded back on itself on the surface of the mounting portion to extend from the mounting portion to the actuator.

7. The electronic device of claim 6,
wherein the key button further includes another shaft portion, extending from the head portion toward the inside of the electronic device, spaced apart from the shaft portion,
wherein the actuator is positioned between the shaft portion and the another shaft portion to provide the haptic feedback to the head portion based on pressure exerted by the another shaft portion, and
wherein the electronic device further comprising another sensor disposed on the mounting portion to detect the pressure exerted by the another shaft portion.

8. The electronic device of any one of claims 1 to 7,
wherein the actuator is aligned with the shaft portion and the sensor to be pressed by the shaft portion.

9. The electronic device of any one of claims 1 to 8, further comprising:
a support plate attached on a surface of the mounting portion toward the key button to support the actuator pressed by the shaft portion, and
wherein the sensor is attached on another surface of the mounting portion opposite to the surface.

10. The electronic device of claim 9,
wherein the actuator includes:
a piezoelectric element providing the haptic feedback based on the pressure; and
a vibration plate, coupled to the piezoelectric element to space the piezoelectric element apart from the support plate, deformable based on the pressure, and
wherein the connecting portion connects the mounting portion and a lateral side of the piezoelectric element which is spaced apart from the support plate by the vibration plate.

11. The electronic device of claim 10,
wherein the vibration plate includes a guide groove dented toward the piezoelectric element, and
wherein the electronic device comprising a first guide structure, attached on the surface of the mounting portion, protruding into an inside of the guide groove.

12. The electronic device of any one of claims 1 to 11,
wherein the key button further includes another shaft portion, extending from the head portion toward the inside of the electronic device, spaced apart from the shaft portion, and
wherein the electronic device further comprising:
another actuator, disposed between the key button and the PCB, configured to provide the haptic feedback to the head portion based on pressure exerted by the another shaft portion, spaced apart from the actuator; and
another sensor disposed on the mounting portion to detect the pressure exerted by the another shaft portion.

13. The electronic device of claim 12 further comprising:
a second guide structure disposed between the actuator and the another actuator.

14. The electronic device of any one of claims 1 to 13,
wherein the key button further includes a hook portion extending from the head portion,
wherein the hook portion is coupled to the housing to prevent the key button from leaving the recess of the housing.

15. The electronic device of any one of claims 1 to 14,
wherein the housing further comprising a second support portion forming a space to accommodate the PCB,
wherein the electronic device further comprising:
a spacer mounted on the second support plate; and
an elastic member interposed between the spacer and the mounting portion of the PCB.
